# EUROPEAN PATENT APPLICATION

(11) **EP 3 285 119 A1**
(43) Date of publication of application: **21.02.2018**
(21) Application number: 16772054.9
(22) Date of filing: 02.03.2016
(51) Int. Cl.: G03F 7/022, C08G 8/04

(54) **RADIATION-SENSITIVE COMPOSITION**

(30) Priority: 31.03.2015 JP 2015073272
(71) Applicant: Mitsubishi Gas Chemical Company, Inc., Tokyo 100-8324 (JP)
(72) Inventor: ECHIGO, Masatoshi, Tokyo 100-8324 (JP); TOIDA, Takumi, Hiratsuka-shi Kanagawa 254-0016 (JP); SATO, Takashi, Hiratsuka-shi Kanagawa 254-0016 (JP)
(74) Representative: Müller-Boré & Partner Patentanwälte PartG mbB
(86) International application number: PCT/JP2016/056337
(87) International publication number: WO 2016/158170

(57) **Abstract**

The present invention provides a radiation-sensitive composition containing (A) a resist base material, (B) an optically active diazonaphthoquinone compound, and (C) a solvent, wherein the content of a solid component in the composition is within the range of 1 to 80% by mass, the content of the solvent is within the range of 20 to 99% by mass, and the resist base material (A) is a compound represented by a specific formula.

## Description

### Technical Field

The present invention relates to a radiation-sensitive composition and a method for forming a resist pattern using the composition.

### Background Art

In lithography upon producing semiconductors, LCD, or solar cells, a photosensitizing agent having a quinonediazide group, such as a naphthoquinonediazide compound, and an alkali soluble resin are used. Positive type photoresists having such composition exhibit high resolving power by development with an alkaline solution and are used in the production of semiconductors such as IC and LSI or the production of circuit base materials such as LCD.

Meanwhile, for the conventional production of most advanced semiconductors, various low molecular weight resist materials have been proposed as resist base materials for offering resist patterns with higher resolution. The low molecular weight resist materials have a small molecular size because of their low molecular weights and are expected to offer resist patterns with high resolution and small roughness.

For example, an alkaline development type chemical amplification positive type radiation-sensitive composition (see e.g., Patent Literature 1) using a low molecular weight polynuclear polyphenolic compound as a main component, and an alkaline development type chemical amplification positive type radiation-sensitive composition (see e.g., Patent Literature 2) using a low molecular weight cyclic polyphenol compound as a main component have been suggested.

### Citation List

### Patent Literature

Patent Literature 1: Japanese Patent Application Laid-Open No. 2005-266741
Patent Literature 2: Japanese Patent Application Laid-Open No. 2012-83731

### Summary of Invention

### Technical Problem

However, resist patterns formed from the compositions described in Patent Literatures 1 and 2 have large roughness. Thus, there has been a demand for further improvement in radiation-sensitive composition.

An object of the present invention is to provide a radiation-sensitive composition which offers a good resist pattern with small roughness and contains a resist base material, an optically active compound, and a solvent, and a method for forming a resist pattern using the composition.

### Solution to Problem

The present inventors have, as a result of devoted examinations to solve the above problems, found out that a radiation-sensitive composition containing a resist base material represented by a specific chemical structural formula, an optically active compound, and a solvent imparts a good shape with small roughness to a resist pattern, and reached the present invention.

More specifically, the present invention is as follows.
[1] A radiation-sensitive composition comprising (A) a resist base material, (B) an optically active diazonaphthoquinone compound, and (C) a solvent, wherein
   the content of a solid component in the composition is within the range of 1 to 80% by mass, the content of the solvent is within the range of 20 to 99% by mass, and
   the resist base material (A) is a compound represented by the following formula (1): 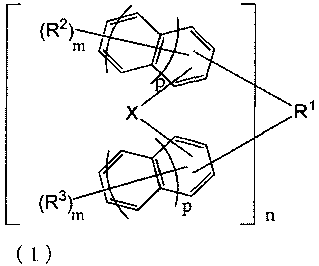 wherein X are each independently an oxygen atom, a sulfur atom, or a non-crosslinked state; R¹ is a single bond or a 2n-valent group of 1 to 30 carbon atoms; R² and R³ are each independently a linear, branched, or cyclic alkyl group of 1 to 10 carbon atoms, an aryl group of 6 to 10 carbon atoms, an alkenyl group of 2 to 10 carbon atoms, a hydroxyl group, or a thiol group; m are each independently an integer of 0 to 7, wherein at least one of m is an integer of 1 to 7; p are each independently 0 or 1; and n is an integer of 1 to 4, wherein at least one selected from the group consisting of R² and R³ is at least one kind selected from a hydroxyl group and a thiol group.
[2] The radiation-sensitive composition according to [1], wherein in the formula (1), at least one selected from the group consisting of R¹, R², and R³ is a group containing an iodine atom.
[3] The radiation-sensitive composition according to [1] or [2], wherein in the formula (1), X is an oxygen atom.
[4] The radiation-sensitive composition according to any of [1] to [3], wherein in the formula (1), X is an oxygen atom, one of R² is a hydroxyl group, and one of R³ is a hydroxyl group.
[5] The radiation-sensitive composition according to any of [1] to [4], wherein the solid component comprises resist base material (A)/optically active diazonaphthoquinone compound (B)/optional component (D) at a ratio of 1 to 99/99 to 1/0 to 98 in % by mass based on the solid component.
[6] The radiation-sensitive composition according to any of [1] to [5], wherein the radiation-sensitive composition is capable of forming an amorphous film by spin coating.
[7] The radiation-sensitive composition according to [6], wherein the dissolution rate of the amorphous film in a developing solution at 23°C is 5 angstrom/sec or less.
[8] The radiation-sensitive composition according to [6] or [7], wherein the dissolution rate of an exposed portion of the amorphous film after irradiation with g-ray, h-ray, i-ray, KrF excimer laser, ArF excimer laser, extreme ultraviolet, electron beam, or X-ray or after heating at 20 to 500°C, in a developing solution at 23°C is 10 angstrom/sec or more.
[9] An amorphous film formed by spin coating with the radiation-sensitive composition according to any of [1] to [8].
[10] The amorphous film according to [9], wherein the dissolution rate of an exposed portion of the amorphous film after irradiation with g-ray, h-ray, i-ray, KrF excimer laser, ArF excimer laser, extreme ultraviolet, electron beam, or X-ray or after heating at 20 to 500°C, in a developing solution at 23°C is 10 angstrom/sec or more.
[11] A method for forming a resist pattern, comprising the steps of: coating a substrate with the radiation-sensitive composition according to any of [1] to [8], thereby forming a resist film; exposing the resist film; and developing the exposed resist film.

### Advantageous Effects of Invention

The present invention can provide a radiation-sensitive composition which offers a good resist pattern with small roughness and contains a resist base material, an optically active compound, and a solvent, and a method for forming a resist pattern using the composition.

### Description of Embodiments

Hereinafter, an embodiment of the present invention (hereinafter, referred to as "present embodiment") will be described in detail. The present embodiment is given in order to illustrate the present invention. The present invention is not limited to only the present embodiment.

### (Radiation-Sensitive Composition)

The radiation-sensitive composition of the present embodiment contains (A) a resist base material represented by a specific chemical structural formula, (B) an optically active compound, and (C) a solvent.

The radiation-sensitive composition of the present embodiment is preferably a radiation-sensitive composition containing 1 to 80% by mass of a solid component and 20 to 99% by mass of the solvent. Particularly preferably, the content of the resist base material (A) is 1 to 99% by mass of the total weight of the solid component.

The radiation-sensitive composition of the present embodiment can offer a good resist pattern with small roughness.

### [(A) Resist Base Material]

The resist base material (A) used in the present embodiment is a compound represented by the following formula (1): 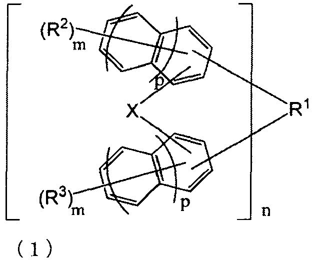 In the formula (1), X are each independently an oxygen atom, a sulfur atom, or a non-crosslinked state. R¹ is a single bond or a 2n-valent group of 1 to 30 carbon atoms. Herein, the 2n-valent group of 1 to 30 carbon atoms may have an alicyclic hydrocarbon group, a double bond, a heteroatom, or an aromatic group of 6 to 30 carbon atoms. In the formula (1), R² and R³ are each independently a linear, branched, or cyclic alkyl group of 1 to 10 carbon atoms, an aryl group of 6 to 10 carbon atoms, an alkenyl group of 2 to 10 carbon atoms, a hydroxyl group, or a thiol group. m are each independently an integer of 0 to 7, wherein at least one of m is an integer of 1 to 7. p are each independently 0 or 1, and n is an integer of 1 to 4. However, at least one selected from the group consisting of R² and R³ is at least one kind selected from a hydroxyl group and a thiol group.

The "at least one selected from the group consisting of R² and R³" means "at least one group selected from the group consisting of R² and R³", and does not mean "at least one kind of group selected from the group consisting of R² and R³".

In the above formula (1), X are each independently an oxygen atom, a sulfur atom, or a non-crosslinked state, and each aromatic ring is bonded at an optional position via this X. In the above formula (1), R¹ is a single bond or a 2n-valent group of 1 to 30 carbon atoms, and each aromatic ring is bonded at an optional position via this R¹. Herein, the 2n-valent group may have an alicyclic hydrocarbon group, a double bond, a heteroatom, or an aromatic group of 6 to 30 carbon atoms. In the above formula (1), R² and R³ are each independently a monovalent substituent selected from the group consisting of a linear, branched, or cyclic alkyl group of 1 to 10 carbon atoms, an aryl group of 6 to 10 carbon atoms, an alkenyl group of 2 to 10 carbon atoms, and a hydroxyl group, and m each of R² and R³ is bonded to the aromatic ring. Herein, at least one selected from the group consisting of R² and R³ is at least one kind selected from a hydroxyl group and a thiol group. In the above formula (1), m are each independently an integer of 0 to 7, wherein at least one of m is an integer of 1 to 7. p are each independently 0 or 1, and n is an integer of 1 to 4.

The above 2n-valent group refers to an alkylene group of 1 to 30 carbon atoms (n = 1), an alkanetetrayl group of 1 to 30 carbon atoms (n = 2), an alkanehexayl group of 2 to 30 carbon atoms (n = 3), or an alkaneoctayl group of 3 to 30 carbon atoms (n = 4). Examples of the above 2n-valent group include hydrocarbon groups having a linear, branched, or cyclic structure.

Also, the above 2n-valent group may have an alicyclic hydrocarbon group, a double bond, a heteroatom, or an aromatic group of 6 to 30 carbon atoms. Herein, the alicyclic hydrocarbon group also includes bridged alicyclic hydrocarbon groups.

Herein, in the compound represented by the above formula (1), from the viewpoint of the supply of raw materials, X in the above formula (1) is preferably an oxygen atom, and specifically, for example, a compound represented by the following formula (1-1) is preferable:

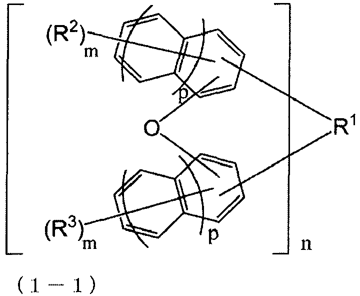

In the above formula (1-1) , R¹, R², R³, m, n, and p are as defined in the description of the above formula (1) .

Also, in the compound represented by the above general formula (1), from the viewpoint of solubility in an organic solvent, more preferably, X in the above formula (1) is an oxygen atom, at least one of R² is a hydroxyl group, and at least one of R³ is a hydroxyl group, and specifically, for example, a compound represented by the following formula (1-2) is more preferable:

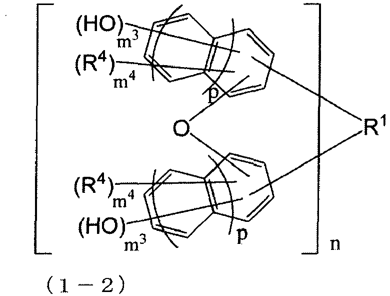

In the above formula (1-2), R¹, p, and n are as defined in the description of the above formula (1). R⁴ is the same as R² described in the above formula (1) except for a hydroxyl group. m³ are each independently an integer of 1 to 6. m⁴ are each independently an integer of 0 to 5. m³ + m⁴ is an integer of 1 to 6.

In the compound represented by the above general formula (1), from the viewpoint of further solubility in an organic solvent, still more preferably, X in the above formula (1) is an oxygen atom, one of R² is a hydroxyl group, and one of R³ is a hydroxyl group, and specifically, for example, a compound represented by the following formula (1-3) is still more preferable:

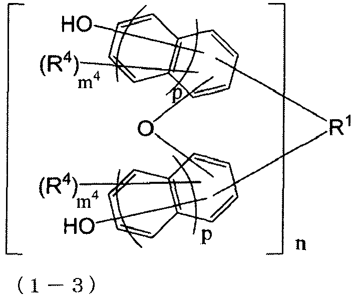

In the above formula (1-3), R¹, p, and n are as defined in the description of the above formula (1). R⁴ and m⁴ are as defined in the description of the above formula (1-2).

Also, in the compound represented by the above formula (1), from the viewpoint of a low molecular weight, p = 1 and n = 1 in the above formula (1) are particularly preferable, and specifically, for example, a compound represented by the following formula (1-4) is preferable:

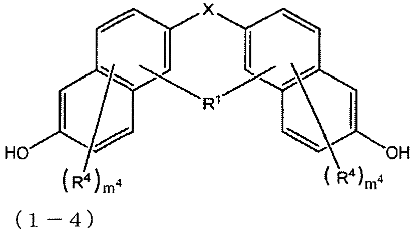

In the above formula (1-4), X and R¹ are as defined in the description of the above formula (1). R⁴ and m⁴ are as defined in the description of the above formula (1-2) .

Furthermore, the compound represented by the above general formula (1-4) is particularly preferably a form in which X = O in the above formula (1-4), that is, a compound represented by the following formula (1-5):

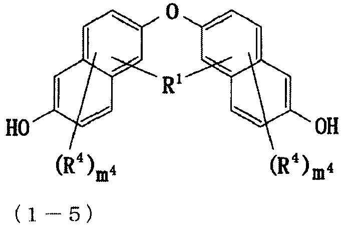

In the above formula (1-5), R¹ is as defined in the description of the above formula (1). R⁴ and m⁴ are as defined in the description of the above formula (1-2).

Specific examples of the compound represented by the above general formula (1) include, but not limited to, the followings:

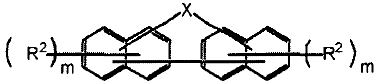

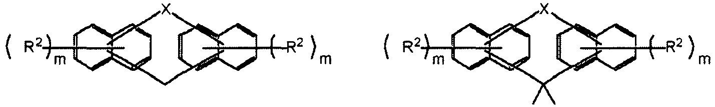

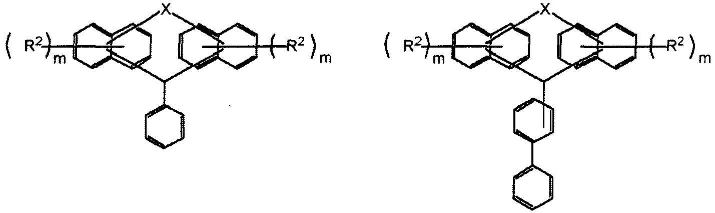

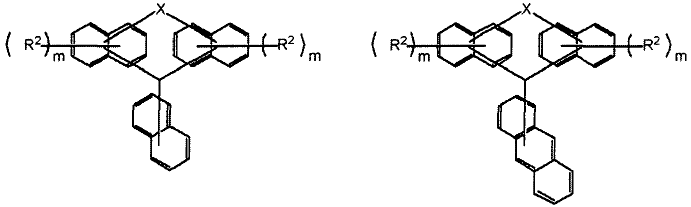

In the above formulae, R², X, and m are as defined in the description of the above formula (1).

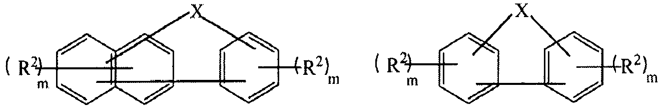

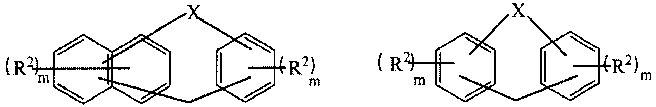

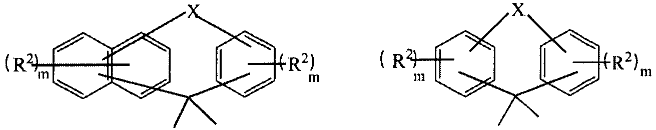

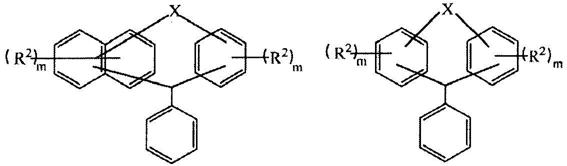

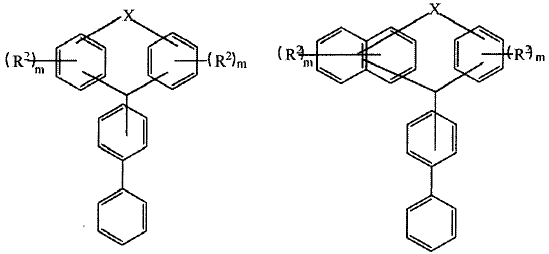

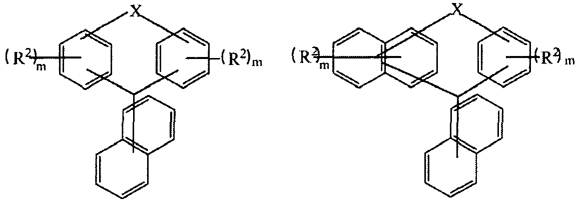

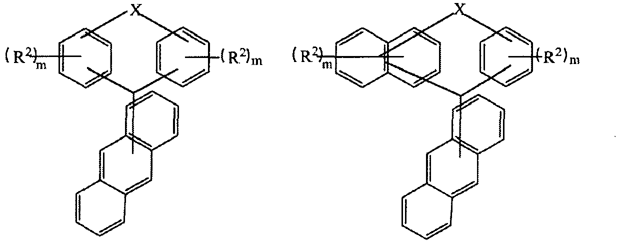

In the above formulae, R², X, and m are as defined in the description of the above formula (1).

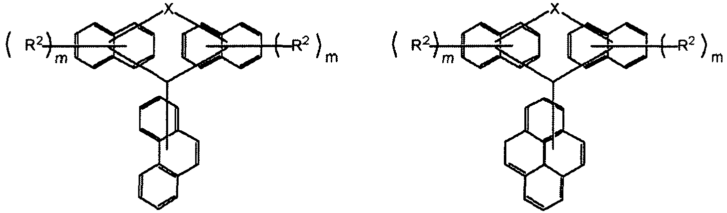

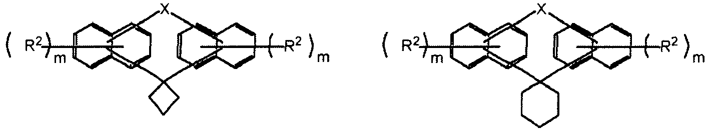

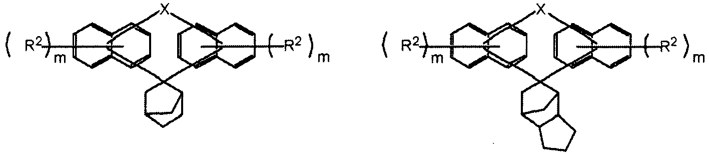

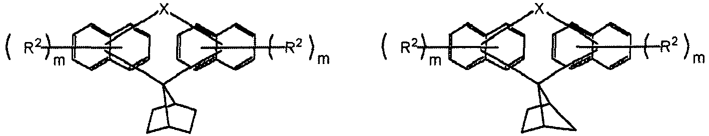

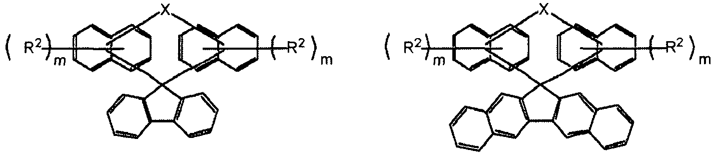

In the above formulae, R², X, and m are as defined in the description of the above formula (1).

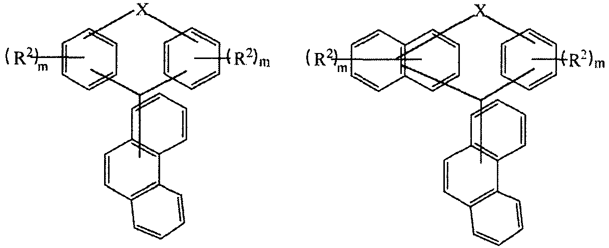

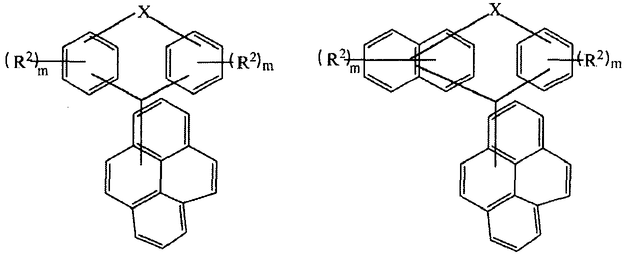

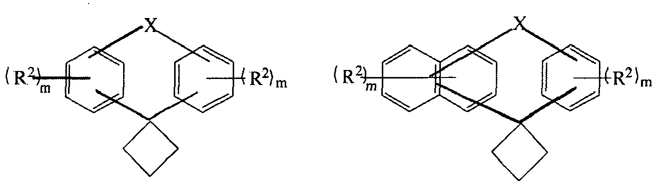

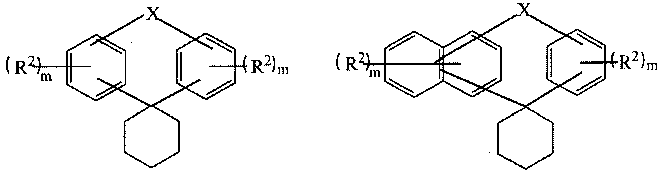

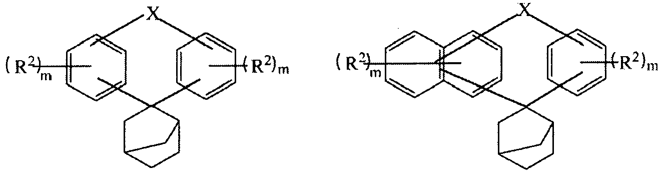

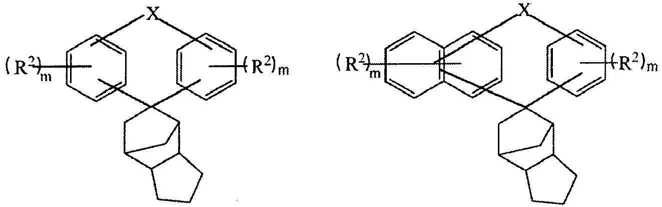

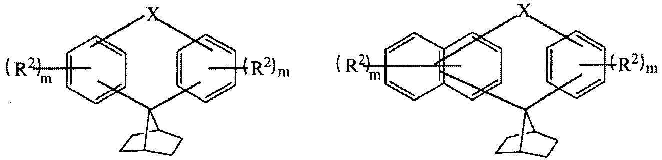

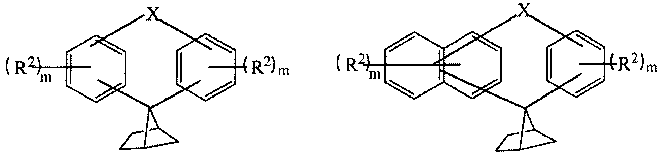

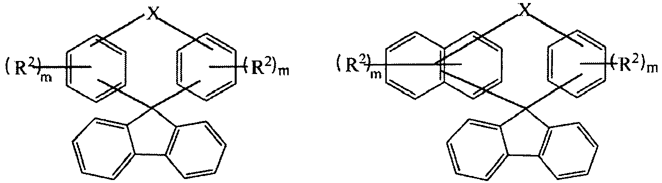

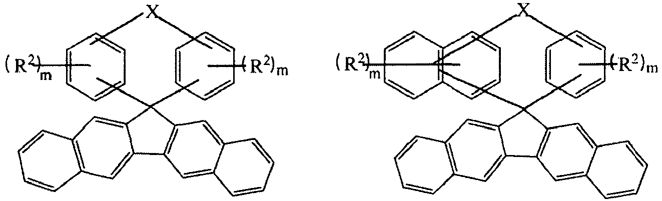

In the above formulae, R², X, and m are as defined in the description of the above formula (1).

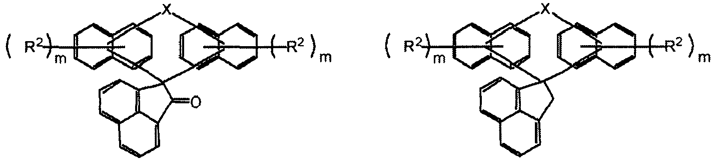

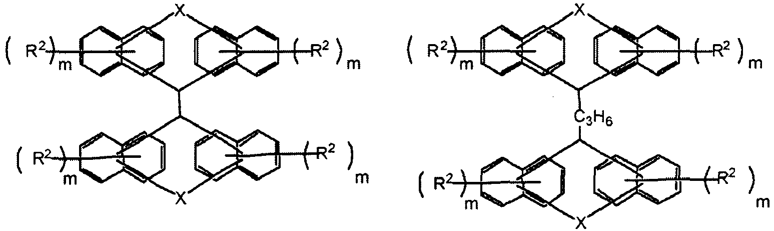

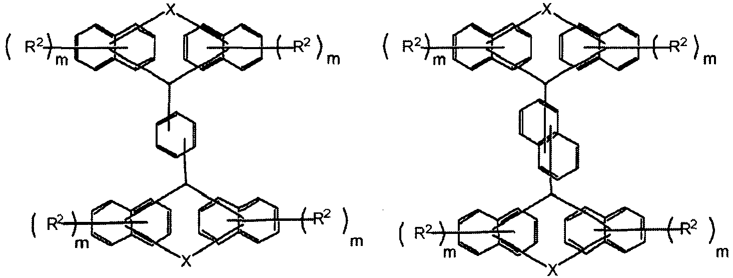

In the above formulae, R², X, and m are as defined in the description of the above formula (1).

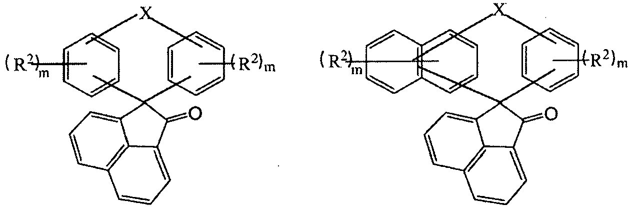

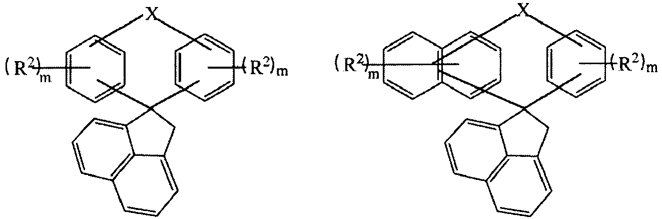

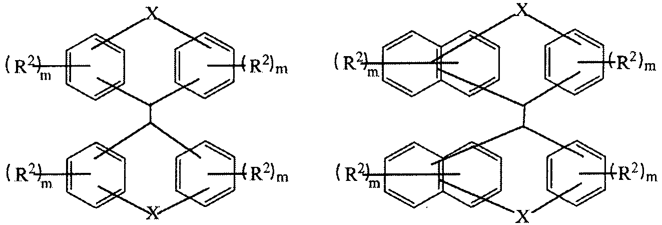

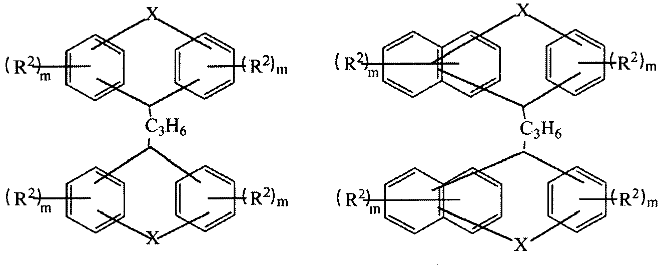

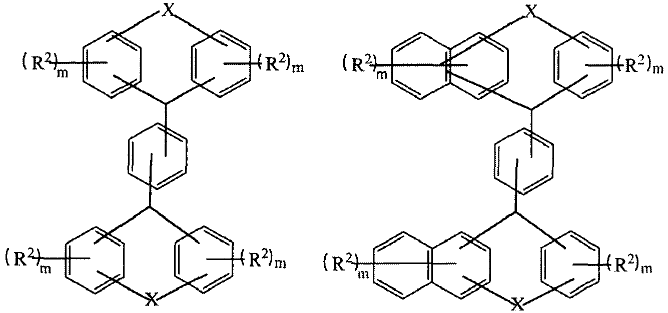

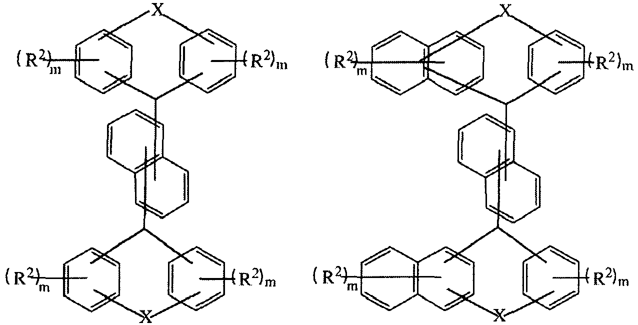

In the above formulae, R², X, and m are as defined in the description of the above formula (1).

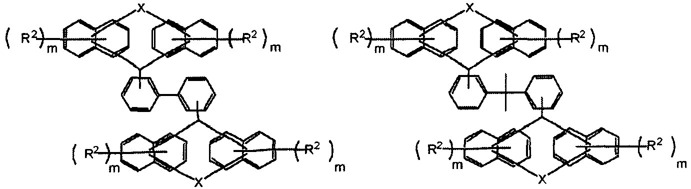

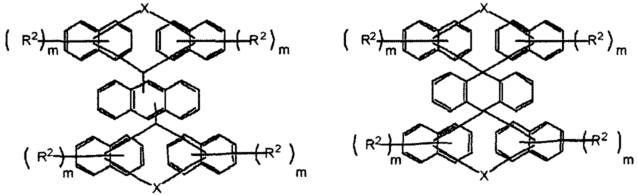

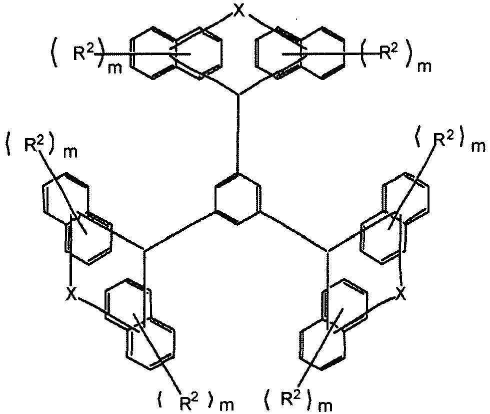

In the above formulae, R², X, and m are as defined in the description of the above formula (1).

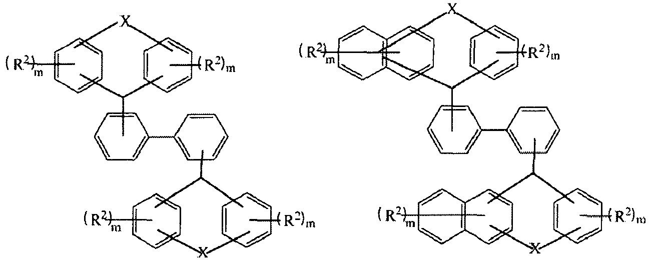

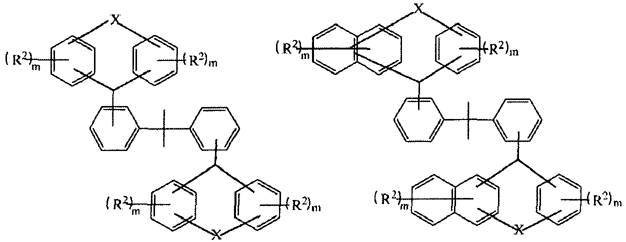

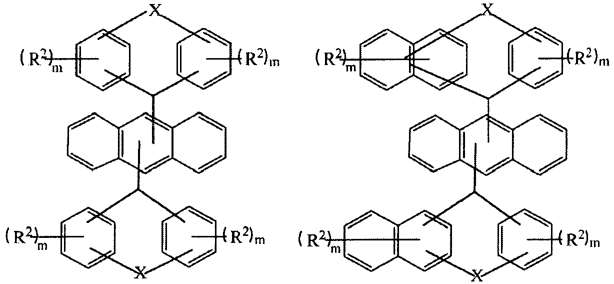

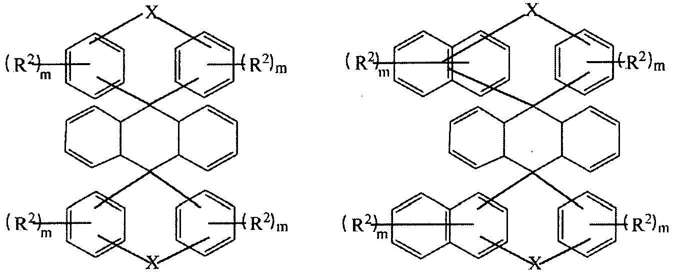

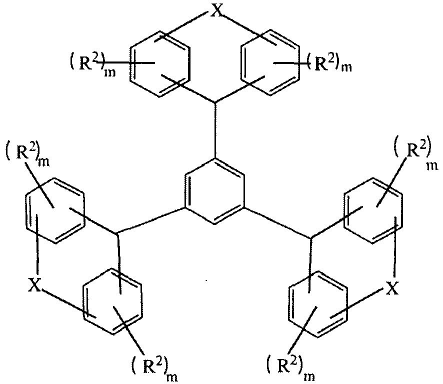

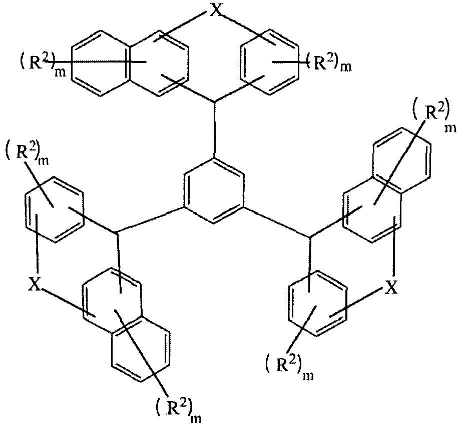

In the above formulae, R², X, and m are as defined in the description of the above formula (1).

Specific examples of the compound represented by the above formula (1) further include, but not limited to, the followings:

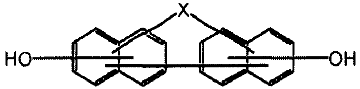

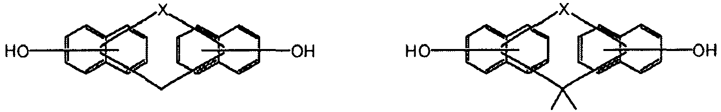

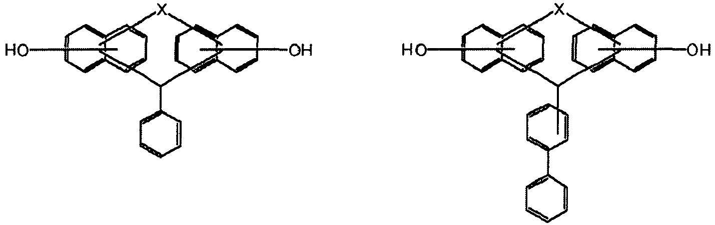

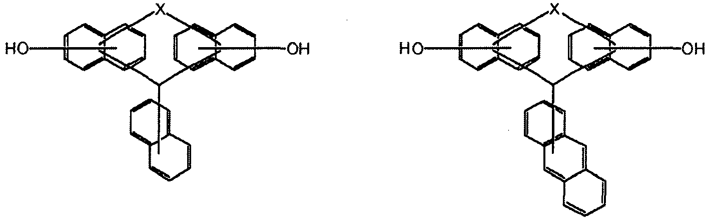

In the above formulae, X is as defined in the description of the above formula (1).

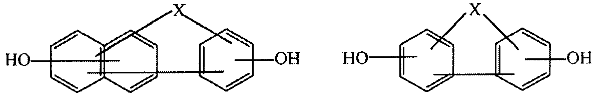

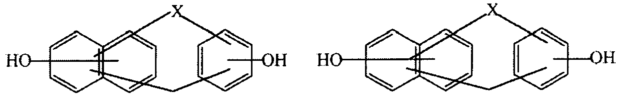

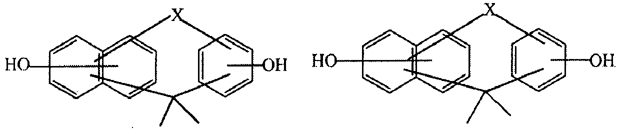

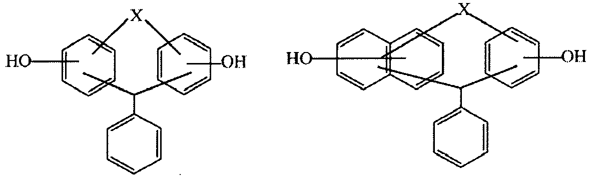

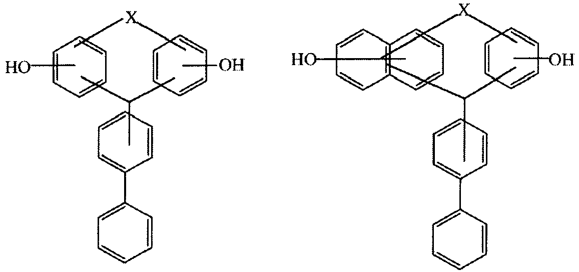

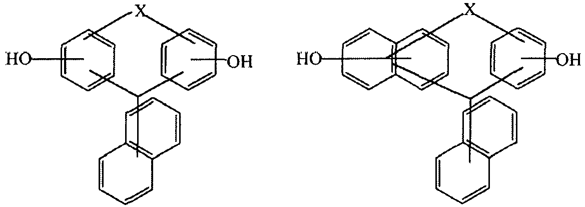

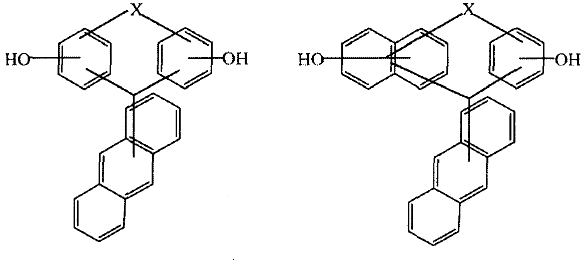

In the above formulae, X is as defined in the description of the above formula (1).

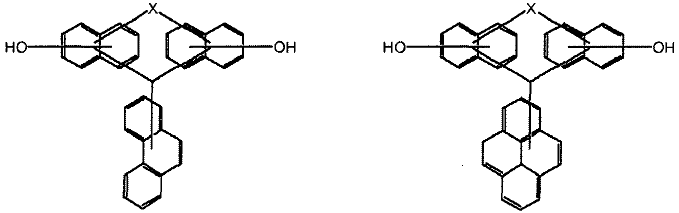

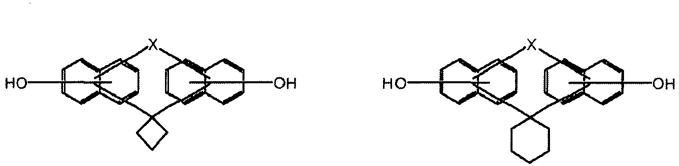

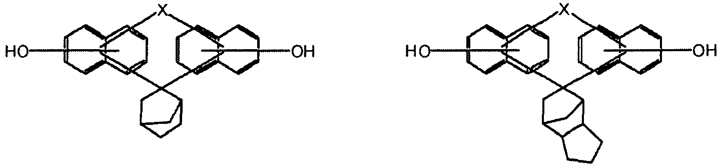

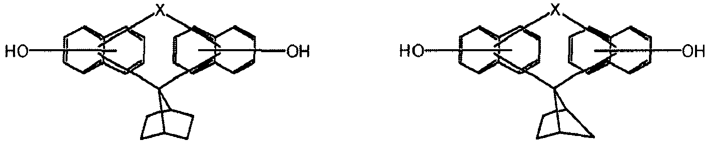

In the above formulae, X is as defined in the description of the above formula (1).

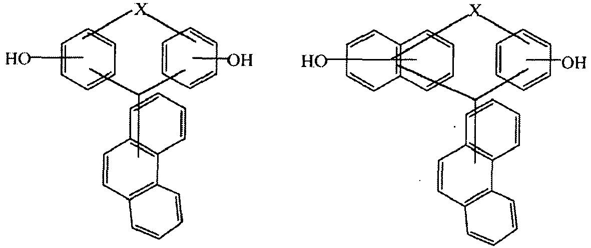

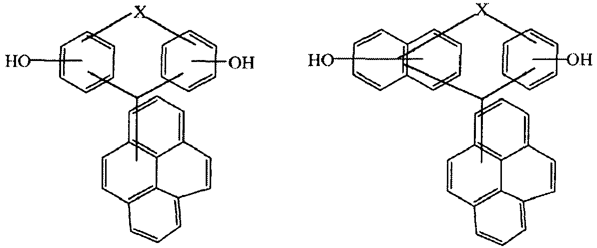

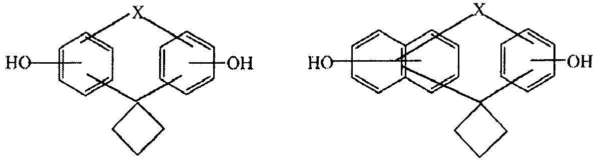

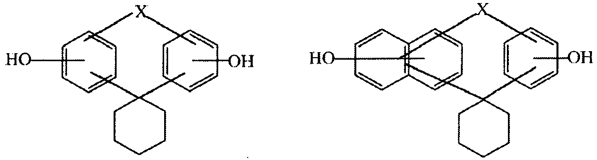

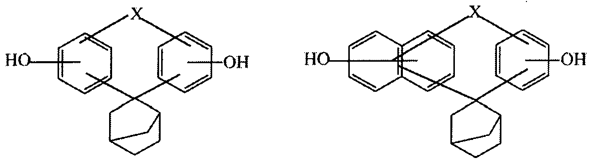

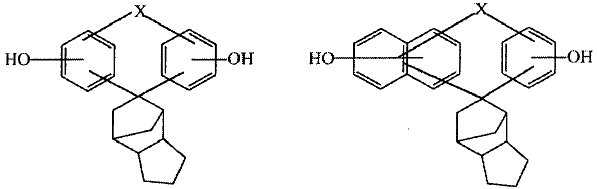

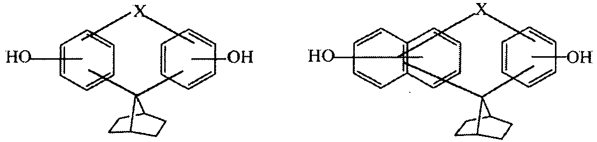

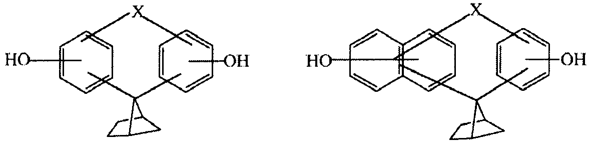

In the above formulae, X is as defined in the description of the above formula (1).

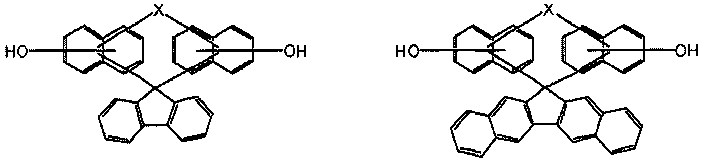

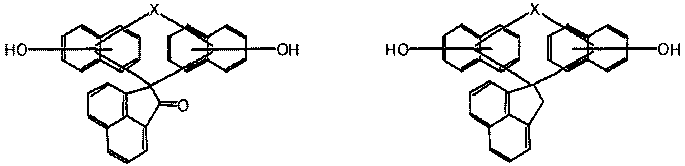

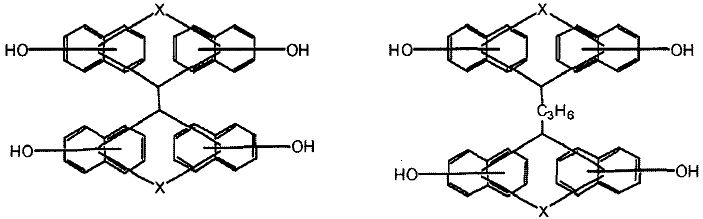

In the above formulae, X is as defined in the description of the above formula (1).

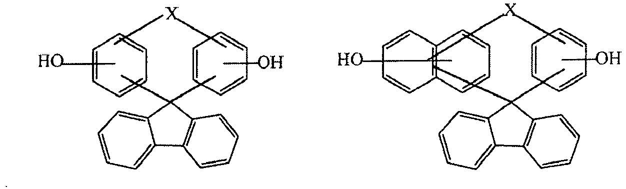

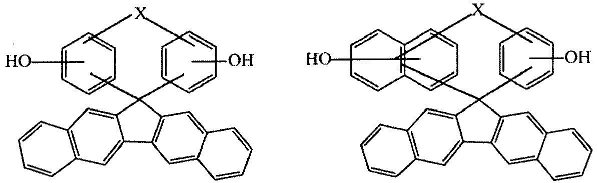

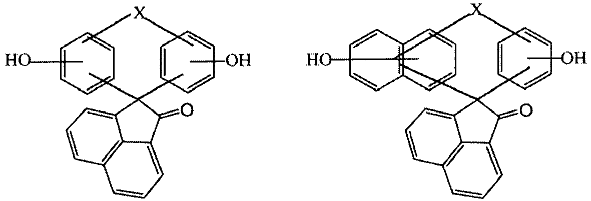

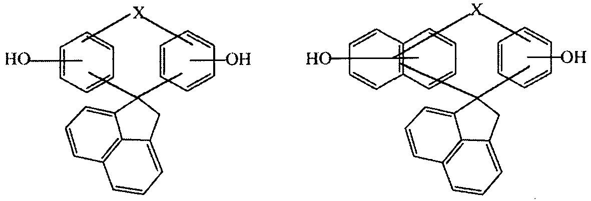

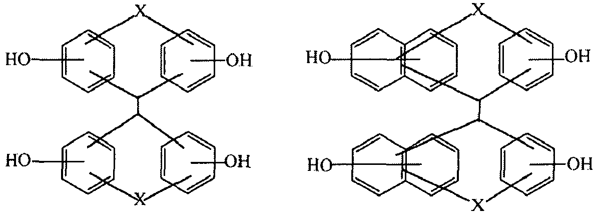

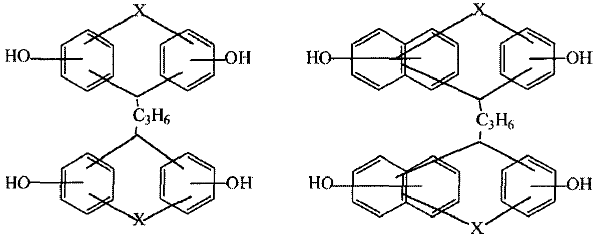

In the above formulae, X is as defined in the description of the above formula (1).

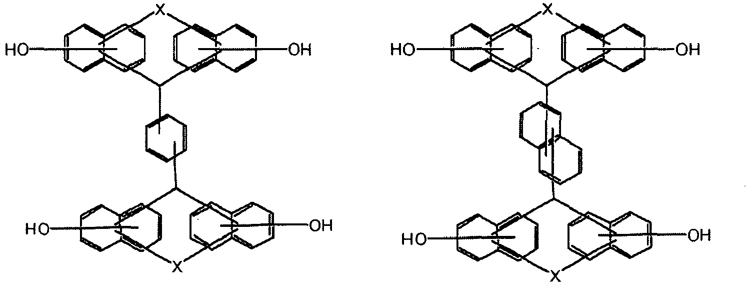

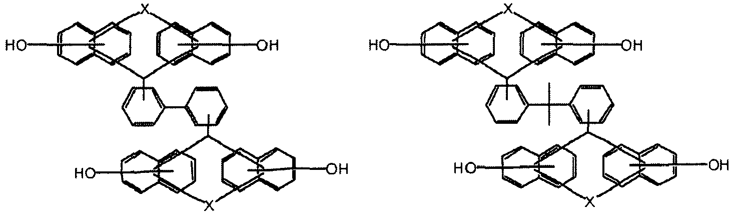

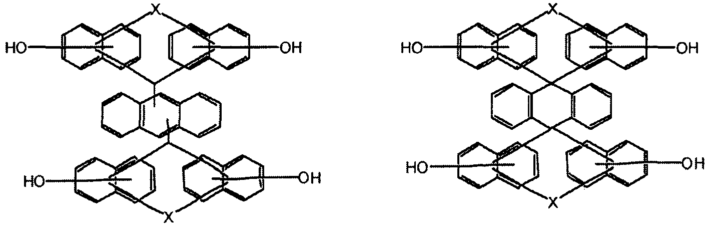

In the above formulae, X is as defined in the description of the above formula (1).

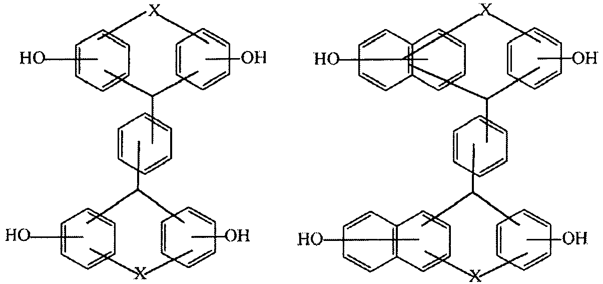

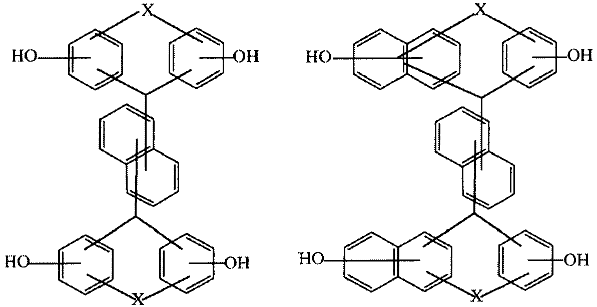

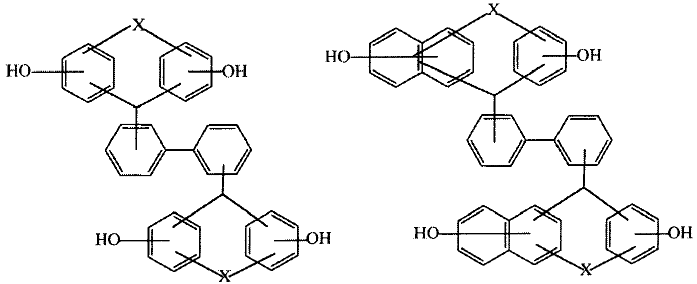

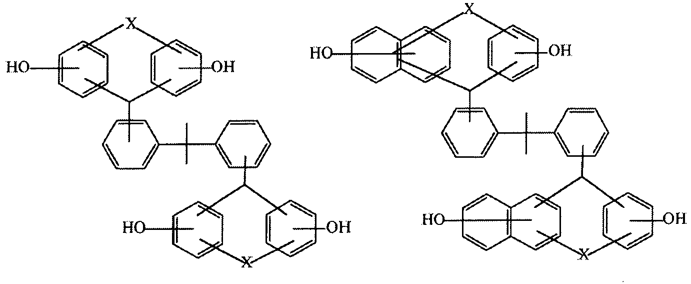

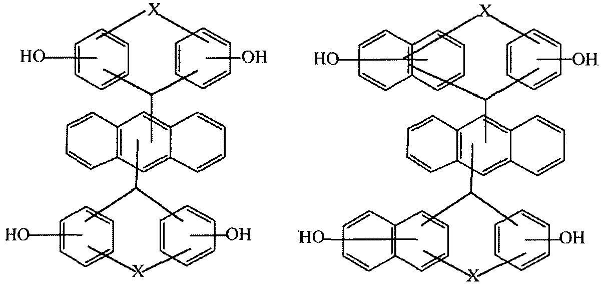

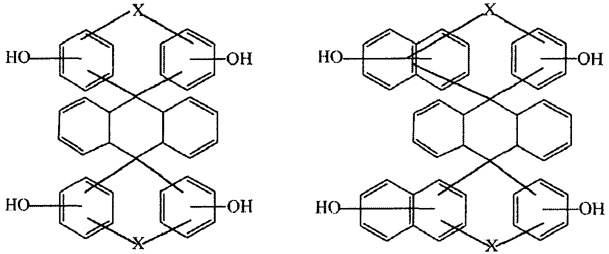

In the above formulae, X is as defined in the description of the above formula (1).

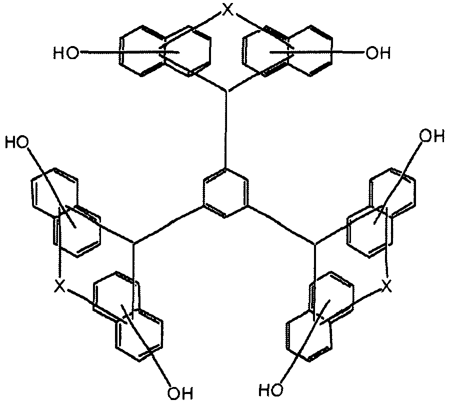

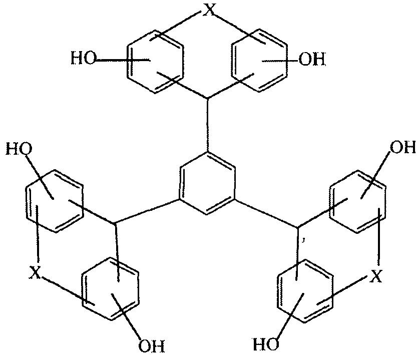

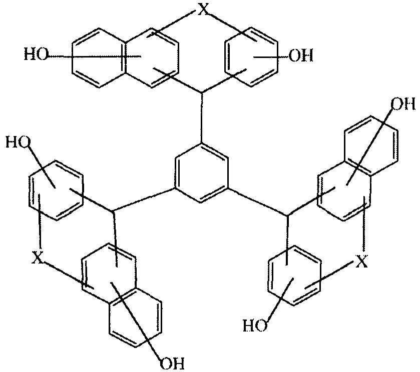

In the above formulae, X is as defined in the description of the above formula (1).

The compound represented by the above formula (1) used in the present embodiment can be arbitrarily synthesized by applying a publicly known approach, and the synthesis approach is not particularly limited. The compound represented by the above formula (1) can be obtained, for example, by subjecting a phenol, a thiophenol, a naphthol, or a thionaphthol, and a corresponding aldehyde or ketone to polycondensation reaction in the presence of an acid catalyst at normal pressure. If necessary, this reaction can also be carried out under increased pressure.

Examples of the phenol include, but not particularly limited to, phenol, methylphenol, methoxybenzene, catechol, resorcinol, hydroquinone, and trimethylhydroquinone. These phenols may be used alone as one kind or may be used in combination of two or more kinds. Among them, hydroquinone or trimethylhydroquinone is more preferably used because a xanthene structure can be easily formed.

Examples of the thiophenol include, but not particularly limited to, benzenethiol, methylbenzenethiol, methoxybenzenethiol, benzenedithiol, and trimethylbenzenedithiol. These thiophenols may be used alone as one kind or may be used in combination of two or more kinds. Among them, benzenedithiol or trimethylbenzenedithiol is more preferably used because a thioxanthene structure can be easily formed.

Examples of the naphthol include, but not particularly limited to, naphthol, methylnaphthol, methoxynaphthol, and naphthalenediol. These naphthols may be used alone as one kind or may be used in combination of two or more kinds. Among them, naphthalenediol is more preferably used because a benzoxanthene structure can be easily formed.

Examples of the thionaphthol include, but not particularly limited to, naphthalenethiol, methylnaphthalenethiol, methoxynaphthalenethiol, and naphthalenedithiol. These thionaphthols may be used alone as one kind or may be used in combination of two or more kinds. Among them, naphthalenedithiol is more preferably used because a thiobenzoxanthene structure can be easily formed.

As the aldehyde, for example, formaldehyde, trioxane, paraformaldehyde, acetaldehyde, propylaldehyde, butylaldehyde, hexylaldehyde, decylaldehyde, undecylaldehyde, phenylacetaldehyde, phenylpropylaldehyde, furfural, benzaldehyde, hydroxybenzaldehyde, fluorobenzaldehyde, chlorobenzaldehyde, nitrobenzaldehyde, methylbenzaldehyde, dimethylbenzaldehyde, ethylbenzaldehyde, propylbenzaldehyde, butylbenzaldehyde, cyclohexylbenzaldehyde, benzaldehyde, hydroxybenzaldehyde, fluorobenzaldehyde, chlorobenzaldehyde, nitrobenzaldehyde, methylbenzaldehyde, dimethylbenzaldehyde, ethylbenzaldehyde, propylbenzaldehyde, butylbenzaldehyde, cyclohexylbenzaldehyde, biphenylaldehyde, naphthaldehyde, anthracenecarboxaldehyde, phenanthrenecarboxaldehyde, pyrenecarboxaldehyde, glyoxal, glutaraldehyde, phthalaldehyde, naphthalenedicarboxaldehyde, biphenyldicarboxaldehyde, anthracenedicarboxaldehyde, bis(diformylphenyl)methane, bis(diformylphenyl)propane, or benzenetricarboxaldehyde is preferably used from the viewpoint of providing high heat resistance.

Examples of the ketone include, but not particularly limited to, acetone, methyl ethyl ketone, cyclobutanone, cyclopentanone, cyclohexanone, norbornanone, tricyclohexanone, tricyclodecanone, adamantanone, fluorenone, benzofluorenone, acenaphthenequinone, acenaphthenone, and anthraquinone. These ketones may be used alone as one kind or may be used in combination of two or more kinds. Among them, cyclopentanone, cyclohexanone, norbornanone, tricyclohexanone, tricyclodecanone, adamantanone, fluorenone, benzofluorenone, acenaphthenequinone, acenaphthenone, or anthraquinone is preferably used from the viewpoint of providing high heat resistance.

The acid catalyst used in the above reaction can be arbitrarily selected from publicly known ones and used without particular limitations. An inorganic acid or an organic acid is widely known as such an acid catalyst. Examples thereof include, but not particularly limited to: inorganic acids such as hydrochloric acid, sulfuric acid, phosphoric acid, hydrobromic acid, and hydrofluoric acid; organic acids such as oxalic acid, malonic acid, succinic acid, adipic acid, sebacic acid, citric acid, fumaric acid, maleic acid, formic acid, p-toluenesulfonic acid, methanesulfonic acid, trifluoroacetic acid, dichloroacetic acid, trichloroacetic acid, trifluoromethanesulfonic acid, benzenesulfonic acid, naphthalenesulfonic acid, and naphthalenedisulfonic acid; Lewis acids such as zinc chloride, aluminum chloride, iron chloride, and boron trifluoride; and solid acids such as tungstosilicic acid, tungstophosphoric acid, silicomolybdic acid, and phosphomolybdic acid. Among them, an organic acid and a solid acid are preferable from the viewpoint of production, and hydrochloric acid or sulfuric acid is preferably used from the viewpoint of production such as easy availability and handleability. The acid catalyst can be used alone as one kind or in combination of two or more kinds. The amount of the acid catalyst used, which can be arbitrarily set according to the kinds of raw materials to be used and the catalyst to be used, reaction conditions or the like, is not particularly limited and is preferably 0.01 to 100 parts by mass based on 100 parts by mass of the reaction raw materials.

In the above reaction, a reaction solvent may be used. The reaction solvent is not particularly limited as long as the reaction of the aldehyde or the ketone to be used with the phenol, the thiophenol, the naphthol, or the thionaphthol proceeds. The reaction solvent can be arbitrarily selected from publicly known ones and used. Examples thereof include water, methanol, ethanol, propanol, butanol, tetrahydrofuran, dioxane, ethylene glycol dimethyl ether, ethylene glycol diethyl ether, and mixed solvents thereof. The solvent can be used alone as one kind or in combination of two or more kinds. The amount of the solvent used, which can be arbitrarily set according to the kinds of raw materials to be used and the catalyst to be used, reaction conditions or the like, is not particularly limited and is preferably within the range of 0 to 2000 parts by mass based on 100 parts by mass of the reaction raw materials. The reaction temperature in the above reaction, which can be arbitrarily selected according to the reactivity of the reaction raw materials, is not particularly limited and is usually within the range of 10 to 200°C.

For obtaining the compound represented by the above general formula (1) used in the present embodiment, a higher reaction temperature is more preferable. Specifically, the range of 60 to 200°C is preferable. The reaction method can be arbitrarily selected from publicly known approaches and used without particular limitations. The method includes, for example, a method of charging the phenol, the thiophenol, the naphthol, or the thionaphthol, the aldehyde or the ketone, and the catalyst in one portion, and a method of dropping the phenol, the thiophenol, the naphthol, or the thionaphthol, and the aldehyde or the ketone in the presence of the catalyst. After the polycondensation reaction terminates, the obtained compound can be isolated according to a routine method without particular limitations. For example, the objective compound can be obtained by adopting a general approach of, for example, elevating the temperature of the reaction vessel to 130 to 230°C in order to remove unreacted raw materials, catalyst, etc. present in the system, and removing volatile portions at about 1 to 50 mmHg.

The reaction proceeds under preferable conditions involving using 1 mol to an excess of the phenol, the thiophenol, the naphthol, or the thionaphthol and 0.001 to 1 mol of the acid catalyst based on 1 mol of the aldehyde or the ketone, and reacting them at 50 to 150°C at normal pressure for about 20 minutes to 100 hours.

The target component can be isolated by a publicly known method after the reaction terminates. An exemplary method can involve concentrating the reaction solution, precipitating the reaction product by the addition of pure water to the obtained concentrate, cooling the reaction solution to room temperature, then separating the precipitates by filtration, filtering and drying the obtained solid matter, then separating and purifying the solid matter from by-products by column chromatography, and distilling off the solvent, followed by filtration and drying to obtain the compound represented by the above general formula (1) which is the objective compound.

The compound represented by the above formula (1) used in the present embodiment may be used alone, or two or more kinds can also be mixed.

If required, the compound may be purified in order to improve the purity of the resist base material and to reduce the amount of residual metals. If an acid catalyst and a promoter remain in the resist base material, the storage stability of a radiation-sensitive composition is generally reduced. Alternatively, if a basic catalyst remains in the resist base material, the sensitivity of a radiation-sensitive composition is generally reduced. Therefore, the resist base material may be purified for the purpose of reducing them.

The purification can be conducted by a publicly known method as long as the resist base material is not denatured. Examples thereof include, but not particularly limited to, a method involving washing with water, a method involving washing with an acidic aqueous solution, a method involving washing with a basic aqueous solution, a method involving treatment with an ion exchange resin, and a method involving treatment by silica gel column chromatography. These purification methods are more preferably conducted in combination of two or more kinds.

The acidic aqueous solution, basic aqueous solution, ion exchange resin, and silica gel column chromatography may be arbitrarily selected from optimal ones according to the metals to be removed, the amounts or types of acidic compounds and basic compounds, the type of the resist base material to be purified or the like. Examples of the acidic aqueous solution include aqueous solutions of hydrochloric acid, nitric acid, or acetic acid having a concentration of 0.01 to 10 mol/L. Examples of the basic aqueous solution include aqueous solutions of ammonia having a concentration of 0.01 to 10 mol/L. Examples of the ion exchange resin include cationic exchange resins, for example, Amberlyst 15J-HG Dry manufactured by Organo Corp.

The resist base material thus purified may be dried. The drying can be conducted by a publicly known method. Examples thereof include, but not particularly limited to, a method of conducting drying in vacuum or drying in hot air under conditions of not denaturing the compound represented by the above formula (1).

The radiation-sensitive composition of the present embodiment can form an amorphous film by spin coating. Also, the radiation-sensitive composition can be applied to a general semiconductor production process.

The resist base material (A) to be contained in the radiation-sensitive composition of the present embodiment is used in combination with the optically active diazonaphthoquinone compound (B) mentioned later and is useful as a base material for positive type resists that becomes a compound easily soluble in a developing solution by irradiation with g-ray, h-ray, i-ray, KrF excimer laser, ArF excimer laser, extreme ultraviolet, electron beam, or X-ray. Although the properties of the resist base material (A) are not largely altered by g-ray, h-ray, i-ray, KrF excimer laser, ArF excimer laser, extreme ultraviolet, electron beam, or X-ray, the optically active diazonaphthoquinone compound (B) poorly soluble in a developing solution is converted to an easily soluble compound so that a resist pattern can be formed in a development step. Since the resist base material (A) to be contained in the radiation-sensitive composition of the present embodiment is a low molecular weight compound as shown in the above formula (1), the obtained resist pattern has very small roughness. In the above formula (1), at least one selected from the group consisting of R¹, R², and R³ is preferably a group containing an iodine atom. In the case of applying such a resist base material (A) having a group containing an iodine atom which is a preferable form to the radiation-sensitive composition of the present embodiment, the ability to absorb radiation such as electron beam, extreme ultraviolet (EUV), or X-ray is increased. As a result, this enables the enhancement of sensitivity, which is very preferable.

The "at least one selected from the group consisting of R¹, R², and R³" means "at least one group selected from the group consisting of R¹, R², and R³", and does not mean "at least one kind of group selected from the group consisting of R¹, R², and R³".

The glass transition temperature of the resist base material (A) to be contained in the radiation-sensitive composition of the present embodiment is preferably 100°C or more, more preferably 120°C or more, still more preferably 140°C or more, and particularly preferably 150°C or more. The upper limit value of the glass transition temperature of the resist base material (A) is not particularly limited and is, for example, 400°C. When the glass transition temperature of the resist base material (A) falls within the above range, the resulting radiation-sensitive composition has heat resistance capable of maintaining a pattern shape in a semiconductor lithography process, and improves performance such as high resolution.

The heat of crystallization determined by the differential scanning calorimetry of the glass transition temperature of the resist base material (A) to be contained in the radiation-sensitive composition of the present embodiment is preferably less than 20 J/g. (Crystallization temperature) - (Glass transition temperature) is preferably 70°C or more, more preferably 80°C or more, still more preferably 100°C or more, and particularly preferably 130°C or more. When the heat of crystallization is less than 20 J/g or (Crystallization temperature) - (Glass transition temperature) falls within the above range, the radiation-sensitive composition easily forms an amorphous film by spin coating, can maintain film formability necessary for a resist over a long period, and can improve resolution.

In the present embodiment, the above heat of crystallization, crystallization temperature, and glass transition temperature can be determined by differential scanning calorimetry using DSC/TA-50WS manufactured by Shimadzu Corp. About 10 mg of a sample is placed in an unsealed container made of aluminum, and the temperature is raised to the melting point or more at a temperature increase rate of 20°C/min in a nitrogen gas stream (50 mL/min). After quenching, again the temperature is raised to the melting point or more at a temperature increase rate of 20°C/min in a nitrogen gas stream (30 mL/min). After further quenching, again the temperature is raised to 400°C at a temperature increase rate of 20°C/min in a nitrogen gas stream (30 mL/min). The temperature at the middle point (where the specific heat is changed into the half) of steps in the baseline shifted in a step-like pattern is defined as the glass transition temperature (Tg). The temperature of the subsequently appearing exothermic peak is defined as the crystallization temperature. The heat can be determined from the area of a region surrounded by the exothermic peak and the baseline and defined as the heat of crystallization.

The resist base material (A) to be contained in the radiation-sensitive composition of the present embodiment is preferably low sublimable at 100°C or lower, preferably 120°C or lower, more preferably 130°C or less, still more preferably 140°C or less, and particularly preferably 150°C or less at normal pressure. The low sublimability means that in thermogravimetry, weight reduction when the resist base material is kept at a predetermined temperature for 10 minutes is 10% or less, preferably 5% or less, more preferably 3% or less, still more preferably 1% or less, and particularly preferably 0.1% or less. The low sublimability can prevent an exposure apparatus from being contaminated by outgassing upon exposure. In addition, a good pattern shape with low roughness can be obtained.

The resist base material (A) to be contained in the radiation-sensitive composition of the present embodiment dissolves at preferably 1% by mass or more, more preferably 5% by mass or more, and still more preferably 10% by mass or more at 23°C in a solvent that is selected from propylene glycol monomethyl ether acetate (PGMEA), propylene glycol monomethyl ether (PGME), cyclohexanone (CHN), cyclopentanone (CPN), 2-heptanone, anisole, butyl acetate, ethyl propionate, and ethyl lactate and exhibits the highest ability to dissolve the resist base material (A). Particularly preferably, the resist base material (A) dissolves at 20% by mass or more at 23°C in a solvent that is selected from PGMEA, PGME, and CHN and exhibits the highest ability to dissolve the resist base material (A). Particularly preferably, the resist base material (A) dissolves at 20% by mass or more at 23°C in PGMEA. When the above conditions are met, the resist base material (A) may be used in a semiconductor production process at a full production scale.

### [(B) Optically Active Diazonaphthoquinone Compound]

The optically active diazonaphthoquinone compound (B) to be contained in the radiation-sensitive composition of the present embodiment is a diazonaphthoquinone substance including a polymer or non-polymer optically active diazonaphthoquinone compound and is not particularly limited as long as it is generally used as a photosensitive component (photosensitizing agent) in positive type resist compositions. One kind or two or more kinds can be optionally selected and used.

Such a photosensitizing agent is preferably a compound obtained by reacting naphthoquinonediazide sulfonic acid chloride, benzoquinonediazide sulfonic acid chloride, or the like with a low molecular weight compound or a high molecular weight compound having a functional group condensable with these acid chlorides. Herein, examples of the functional group condensable with the acid chlorides include, but not particularly limited to, a hydroxyl group and an amino group. Particularly, a hydroxyl group is preferable. Examples of the compound containing a hydroxyl group condensable with the acid chlorides can include, but not particularly limited to, hydroquinone, resorcin, hydroxybenzophenones such as 2,4-dihydroxybenzophenone, 2,3,4-trihydroxybenzophenone, 2,4,6-trihydroxybenzophenone, 2,4,4'-trihydroxybenzophenone, 2,3,4,4'-tetrahydroxybenzophenone, 2,2',4,4'-tetrahydroxybenzophenone, and 2,2',3,4,6'-pentahydroxybenzophenone, hydroxyphenylalkanes such as bis(2,4-dihydroxyphenyl)methane, bis(2,3,4-trihydroxyphenyl)methane, and bis(2,4-dihydroxyphenyl)propane, and hydroxytriphenylmethanes such as 4,4',3",4"-tetrahydroxy-3,5,3',5'-tetramethyltriphenylmethane and 4,4' ,2" ,3" ,4"-pentahydroxy-3,5,3',5'-tetramethyltriphenylmethane.

Preferable examples of the acid chlorides such as naphthoquinonediazide sulfonic acid chloride and benzoquinonediazide sulfonic acid chloride include 1,2-naphthoquinonediazide-5-sulfonyl chloride and 1,2-naphthoquinonediazide-4-sulfonyl chloride.

### [(C) Solvent]

The radiation-sensitive composition of the present embodiment contains (C) a solvent.

The radiation-sensitive composition of the present embodiment is preferably prepared, for example, by dissolving each component in the solvent upon use into a homogenous solution, and then if required, filtering through a filter or the like with a pore diameter of about 0.2 µm, for example.

Examples of (C) the solvent to be contained in the radiation-sensitive composition of the present embodiment can include, but not particularly limited to, ethylene glycol monoalkyl ether acetates such as ethylene glycol monomethyl ether acetate, ethylene glycol monoethyl ether acetate, ethylene glycol mono-n-propyl ether acetate, and ethylene glycol mono-n-butyl ether acetate; ethylene glycol monoalkyl ethers such as ethylene glycol monomethyl ether and ethylene glycol monoethyl ether; propylene glycol monoalkyl ether acetates such as propylene glycol monomethyl ether acetate, propylene glycol monoethyl ether acetate, propylene glycol mono-n-propyl ether acetate, and propylene glycol mono-n-butyl ether acetate; propylene glycol monoalkyl ethers such as propylene glycol monomethyl ether and propylene glycol monoethyl ether; ester lactates such as methyl lactate, ethyl lactate, n-propyl lactate, n-butyl lactate, and n-amyl lactate; aliphatic carboxylic acid esters such as methyl acetate, ethyl acetate, n-propyl acetate, n-butyl acetate, n-amyl acetate, n-hexyl acetate, methyl propionate, and ethyl propionate; other esters such as methyl 3-methoxypropionate, ethyl 3-methoxypropionate, methyl 3-ethoxypropionate, ethyl 3-ethoxypropionate, methyl 3-methoxy-2-methylpropionate, 3-methoxybutylacetate, 3-methyl-3-methoxybutylacetate, butyl 3-methoxy-3-methylpropionate, butyl 3-methoxy-3-methylbutyrate, methyl acetoacetate, methyl pyruvate, and ethyl pyruvate; aromatic hydrocarbons such as toluene and xylene; ketones such as 2-heptanone, 3-heptanone, 4-heptanone, cyclopentanone, and cyclohexanone; amides such as N,N-dimethylformamide, N-methylacetamide, N,N-dimethylacetamide, and N-methylpyrrolidone; and lactones such as γ-lactone. These solvents can be used alone or in combination of two or more kinds.

### [Proportions of Solid Component and Solvent]

In the radiation-sensitive composition of the present embodiment, preferably, the content of the solid component is 1 to 80% by mass, and the content of the solvent is 20 to 99% by mass. More preferably, the content of the solid component is 1 to 50% by mass, and the content of the solvent is 50 to 99% by mass. Still more preferably, the content of the solid component is 2 to 40% by mass, and the content of the solvent is 60 to 98% by mass. Particularly preferably, the content of the solid component is 2 to 10% by mass, and the content of the solvent is 90 to 98% by mass.

### [Characteristics of Radiation-Sensitive Composition]

The radiation-sensitive composition of the present embodiment can form an amorphous film by spin coating. The dissolution rate of the amorphous film formed by spin coating with the radiation-sensitive composition of the present embodiment in a developing solution at 23°C is preferably 5 angstrom/sec or less, more preferably 0.05 to 5 angstrom/sec, and still more preferably 0.0005 to 5 angstrom/sec. When the dissolution rate is 5 angstrom/sec or less, the amorphous film is insoluble in a developing solution, and can produce a resist. When the amorphous film has the dissolution rate of 0.0005 angstrom/sec or more, the resolution may be improved. It is presumed that this is because due to the change in the solubility before and after exposure of the compound represented by the above formula (1), contrast at the interface between the exposed portion being dissolved in a developing solution and the unexposed portion not being dissolved in a developing solution is increased. Moreover, reduction effects of roughness and defect are obtained.

The dissolution rate of the exposed portion of the amorphous film formed by spin coating with the radiation-sensitive composition of the present embodiment, after irradiation with radiation such as KrF excimer laser, extreme ultraviolet, electron beam or X-ray or after heating at 20 to 500°C, in a developing solution at 23°C is preferably 10 angstrom/sec or more, more preferably 10 to 10000 angstrom/sec, and still more preferably 100 to 1000 angstrom/sec. When the dissolution rate is 10 angstrom/sec or more, the amorphous film dissolves in a developing solution, and can produce a resist. When the amorphous film has the dissolution rate of 10000 angstrom/sec or less, the resolution may be improved. It is presumed that this is because the micro surface portion of the compound represented by the above formula (1) dissolves and roughness is reduced. Moreover, reduction effects of defect are obtained.

### [Content Ratio of Each Component]

In the radiation-sensitive composition of the present embodiment, the content of the resist base material (A) is preferably 1 to 99% by mass based on the total weight of the solid component (summation of optionally used solid component such as resist base material (A), optically active diazonaphthoquinone compound (B), and other component (D), hereinafter the same), more preferably 5 to 95% by mass, still more preferably 10 to 90% by mass, and particularly preferably 25 to 75% by mass. When the content of the resist base material (A) falls within the above range, the radiation-sensitive composition of the present embodiment can produce a pattern with high sensitivity and small roughness.

In the radiation-sensitive composition of the present embodiment, the content of the optically active diazonaphthoquinone compound (B) is preferably 1 to 99% by mass based on the total weight of the solid component (summation of optionally used solid component such as resist base material (A), optically active diazonaphthoquinone compound (B), and other component (D), hereinafter the same), more preferably 5 to 95% by mass, still more preferably 10 to 90% by mass, and particularly preferably 25 to 75% by mass. When the content of the optically active diazonaphthoquinone compound (B) falls within the above range, the radiation-sensitive composition of the present embodiment can produce a pattern with high sensitivity and small roughness.

### [(D) Other Component]

To the radiation-sensitive composition of the present embodiment, within the range of not inhibiting the purpose of the present invention, if required, as the other component (D) (also referred to as "optional component (D)"), one kind or two kinds or more of various additive agents such as an acid generating agent, an acid crosslinking agent, an acid diffusion controlling agent, a dissolution promoting agent, a dissolution controlling agent, a sensitizing agent, a surfactant and an organic carboxylic acid or an oxo acid of phosphor, or derivative thereof can be added.

### (1) Acid Generating Agent

The radiation-sensitive composition of the present embodiment preferably contains one or more acid generating agent generating an acid directly or indirectly by irradiation of any radiation selected from visible light, ultraviolet, excimer laser, electron beam, extreme ultraviolet (EUV), X-ray, and ion beam. In the radiation-sensitive composition of the present embodiment, the amount of the acid generating agent used is preferably 0.001 to 49% by mass of the total weight of the solid component, more preferably 1 to 40% by mass, still more preferably 3 to 30% by mass, and particularly preferably 10 to 25% by mass. By using the acid generating agent within the above range, the radiation-sensitive composition of the present embodiment can produce a pattern profile with high sensitivity and low edge roughness. In the present embodiment, the acid generation method is not limited as long as an acid is generated in the system. By using excimer laser instead of ultraviolet such as g-ray and i-ray, finer processing is possible, and also by using electron beam, extreme ultraviolet, X-ray or ion beam as a high energy ray, further finer processing is possible.

The acid generating agent is preferably at least one kind selected from the group consisting of compounds represented by the following formulae (7-1) to (7-8): 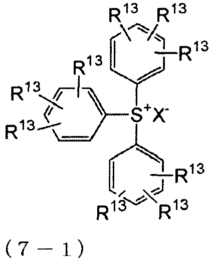 (In the formula (7-1), R¹³ may be the same or different, and are each independently a hydrogen atom, a linear, branched or cyclic alkyl group, a linear, branched or cyclic alkoxy group, a hydroxyl group, or a halogen atom; X- is an alkyl group, an aryl group, a sulfonic acid ion having a halogen substituted alkyl group or a halogen substituted aryl group, or a halide ion.)

The compound represented by the above formula (7-1) is preferably at least one kind selected from the group consisting of triphenylsulfonium trifluoromethanesulfonate, triphenylsulfonium nonafluoro-n-butanesulfonate, diphenyltolylsulfonium nonafluoro-n-butanesulfonate, triphenylsulfonium perfluoro-n-octanesulfonate, diphenyl-4-methylphenylsulfonium trifluoromethanesulfonate, di-2,4,6-trimethylphenylsulfonium trifluoromethanesulfonate, diphenyl-4-t-butoxyphenylsulfonium trifluoromethanesulfonate, diphenyl-4-t-butoxyphenylsulfonium nonafluoro-n-butanesulfonate, diphenyl-4-hydroxyphenylsulfonium trifluoromethanesulfonate, bis(4-fluorophenyl)-4-hydroxyphenylsulfonium trifluoromethanesulfonate, diphenyl-4-hydroxyphenylsulfonium nonafluoro-n-butanesulfonate, bis(4-hydroxyphenyl)-phenylsulfonium trifluoromethanesulfonate, tri(4-methoxyphenyl)sulfonium trifluoromethanesulfonate, tri(4-fluorophenyl)sulfonium trifluoromethanesulfonate, triphenylsulfonium p-toluenesulfonate, triphenylsulfonium benzenesulfonate, diphenyl-2,4,6-trimethylphenyl-p-toluenesulfonate, diphenyl-2,4,6-trimethylphenylsulfonium-2-trifluoromethylbenzenesulfonate, diphenyl-2,4,6-trimethylphenylsulfonium-4-trifluoromethylbenzenesulfonate, diphenyl-2,4,6-trimethylphenylsulfonium-2,4-difluorobenzenesulfonate, diphenyl-2,4,6-trimethylphenylsulfonium hexafluorobenzenesulfonate, diphenylnaphthylsulfonium trifluoromethanesulfonate, diphenyl-4-hydroxyphenylsulfonium-p-toluenesulfonate, triphenylsulfonium 10-camphorsulfonate, diphenyl-4-hydroxyphenylsulfonium 10-camphorsulfonate, and cyclo(1,3-perfluoropropanedisulfone)imidate. 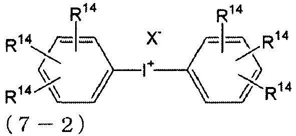 (In the formula (7-2), R¹⁴ may be the same or different, and each independently represents a hydrogen atom, a linear, branched or cyclic alkyl group, a linear, branched or cyclic alkoxy group, a hydroxyl group, or a halogen atom. X⁻ is the same as above.)

The compound represented by the above formula (7-2) is preferably at least one kind selected from the group consisting of bis(4-t-butylphenyl)iodonium trifluoromethanesulfonate, bis(4-t-butylphenyl)iodonium nonafluoro-n-butanesulfonate, bis(4-t-butylphenyl)iodonium perfluoro-n-octanesulfonate, bis(4-t-butylphenyl)iodonium p-toluenesulfonate, bis(4-t-butylphenyl)iodonium benzenesulfonate, bis(4-t-butylphenyl)iodonium-2-trifluoromethylbenzenesulfonate, bis(4-t-butylphenyl)iodonium-4-trifluoromethylbenzenesulfonate, bis(4-t-butylphenyl)iodonium-2,4-difluorobenzenesulfonate, bis(4-t-butylphenyl)iodonium hexafluorobenzenesulfonate, bis(4-t-butylphenyl)iodonium 10-camphorsulfonate, diphenyliodonium trifluoromethanesulfonate, diphenyliodonium nonafluoro-n-butanesulfonate, diphenyliodonium perfluoro-n-octanesulfonate, diphenyliodonium p-toluenesulfonate, diphenyliodonium benzenesulfonate, diphenyliodonium 10-camphorsulfonate, diphenyliodonium-2-trifluoromethylbenzenesulfonate, diphenyliodonium-4-trifluoromethylbenzenesulfonate, diphenyliodonium-2,4-difluorobenzenesulfonate, diphenyliodonium hexafluorobenzenesulfonate, di(4-trifluoromethylphenyl)iodonium trifluoromethanesulfonate, di(4-trifluoromethylphenyl)iodonium nonafluoro-n-butanesulfonate, di(4-trifluoromethylphenyl)iodonium perfluoro-n-octanesulfonate, di(4-trifluoromethylphenyl)iodonium p-toluenesulfonate, di(4-trifluoromethylphenyl)iodonium benzenesulfonate, and di(4-trifluoromethylphenyl)iodonium 10-camphersulfonate. 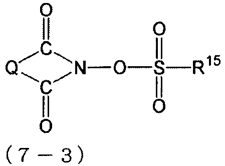 (In the formula (7-3), Q is an alkylene group, an arylene group, or an alkoxylene group, and R¹⁵ is an alkyl group, an aryl group, a halogen substituted alkyl group, or a halogen substituted aryl group.)

The compound represented by the above formula (7-3) is preferably at least one kind selected from the group consisting of N-(trifluoromethylsulfonyloxy)succinimide, N-(trifluoromethylsulfonyloxy)phthalimide, N-(trifluoromethylsulfonyloxy)diphenylmaleimide, N-(trifluoromethylsulfonyloxy)bicyclo[2.2.1]hept-5-en-2,3-dicarboxyimide, N-(trifluoromethylsulfonyloxy)naphthylimide, N-(10-camphorsulfonyloxy)succinimide, N-(10-camphorsulfonyloxy)phthalimide, N-(10-camphorsulfonyloxy)diphenylmaleimide, N-(10-camphorsulfonyloxy)bicyclo[2.2.1]hept-5-en-2,3-dicarboxyimide, N-(10-camphorsulfonyloxy)naphthylimide, N-(n-octanesulfonyloxy)bicyclo[2.2.1]hept-5-en-2,3-dicarboxyimide, N-(n-octanesulfonyloxy)naphthylimide, N-(p-toluenesulfonyloxy)bicyclo[2.2.1]hept-5-en-2,3-dicarboxyimide, N-(p-toluenesulfonyloxy)naphthylimide, N-(2-trifluoromethylbenzenesulfonyloxy)bicyclo[2.2.1]hept-5-en-2,3-dicarboxyimide, N-(2-trifluoromethylbenzenesulfonyloxy)naphthylimide, N-(4-trifluoromethylbenzenesulfonyloxy)bicyclo[2.2.1]hept-5-en-2,3-dicarboxyimide, N-(4-trifluoromethylbenzenesulfonyloxy)naphthylimide, N-(perfluorobenzenesulfonyloxy)bicyclo[2.2.1]hept-5-en-2,3-dicarboxyimide, N-(perfluorobenzenesulfonyloxy)naphthylimide, N-(1-naphthalenesulfonyloxy)bicyclo[2.2.1]hept-5-en-2,3-dicarboxyimide, N-(1-naphthalenesulfonyloxy)naphthylimide, N-(nonafluoro-n-butanesulfonyloxy)bicyclo[2.2.1]hept-5-en-2,3-dicarboxyimide, N-(nonafluoro-n-butanesulfonyloxy)naphthylimide, N-(perfluoro-n-octanesulfonyloxy)bicyclo[2.2.1]hept-5-en-2,3-dicarboxyimide, and N-(perfluoro-n-octanesulfonyloxy)naphthylimide. 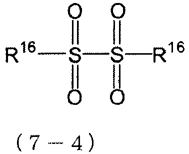 (In the formula (7-4), R¹⁶ may be the same or different, and are each independently an optionally substituted linear, branched or cyclic alkyl group, an optionally substituted aryl group, an optionally substituted heteroaryl group, or an optionally substituted aralkyl group.)

The compound represented by the above formula (7-4) is preferably at least one kind selected from the group consisting of diphenyldisulfone, di(4-methylphenyl)disulfone, dinaphthyldisulfone, di(4-tert-butylphenyl)disulfone, di(4-hydroxyphenyl)disulfone, di(3-hydroxynaphthyl)disulfone, di(4-fluorophenyl)disulfone, di(2-fluorophenyl)disulfone, and di(4-trifluoromethylphenyl)disulfone. 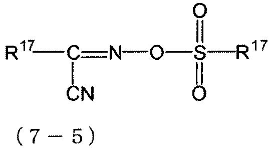 (In the formula (7-5), R¹⁷ may be the same or different, and are each independently an optionally substituted linear, branched or cyclic alkyl group, an optionally substituted aryl group, an optionally substituted heteroaryl group, or an optionally substituted aralkyl group.)

The compound represented by the above formula (7-5) is preferably at least one kind selected from the group consisting of α-(methylsulfonyloxyimino)-phenylacetonitrile, α-(methylsulfonyloxyimino)-4-methoxyphenylacetonitrile, α-(trifluoromethylsulfonyloxyimino)-phenylacetonitrile, α-(trifluoromethylsulfonyloxyimino)-4-methoxyphenylacetonitrile, α-(ethylsulfonyloxyimino)-4-methoxyphenylacetonitrile, α-(propylsulfonyloxyimino)-4-methylphenylacetonitrile, and α-(methylsulfonyloxyimino)-4-bromophenylacetonitrile. 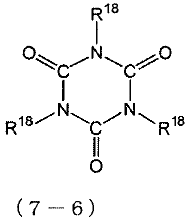 In the formula (7-6), R¹⁸ may be the same or different, and are each independently a halogenated alkyl group having one or more chlorine atoms and one or more bromine atoms. The number of carbon atoms in the halogenated alkyl group is preferably 1 to 5.

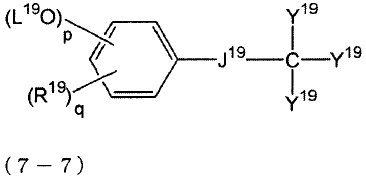

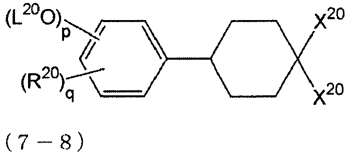

In the formulae (7-7) and (7-8), R¹⁹ and R²⁰ are each independently an alkyl group of 1 to 3 carbon atoms such as a methyl group, an ethyl group, an n-propyl group, and an isopropyl group; a cycloalkyl group such as a cyclopentyl group and a cyclohexyl group; an alkoxyl group of 1 to 3 carbon atoms such as a methoxy group, an ethoxy group, and a propoxy group; or an aryl group such as a phenyl group, a toluoyl group, and a naphthyl group, and preferably an aryl group of 6 to 10 carbon atoms. L¹⁹ and L²⁰ are each independently an organic group having a 1,2-naphthoquinonediazide group. Specifically, preferable examples of the organic group having a 1,2-naphthoquinonediazide group include a 1,2-quinonediazidesulfonyl group such as a 1,2-naphthoquinonediazide-4-sulfonyl group, a 1,2-naphthoquinonediazide-5-sulfonyl group, and a 1,2-naphthoquinonediazide-6-sulfonyl group. A 1,2-naphthoquinonediazide-4-sulfonyl group and a 1,2-naphthoquinonediazide-5-sulfonyl group are particularly preferable. p is an integer of 1 to 3; q is an integer of 0 to 4; and 1≤ p+q≤5. J¹⁹ is a single bond, a polymethylene group of 1 to 4 carbon atoms, a cycloalkylene group, a phenylene group, a group represented by the following formula (7-7-1), a carbonyl group, an ester group, an amide group, or an ether group. Y¹⁹ is a hydrogen atom, an alkyl group, or an aryl group, and X²⁰ are each independently a group represented by the following formula (7-8-1): 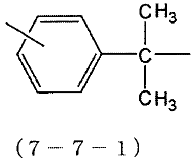 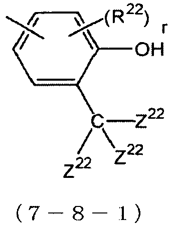 (In the above formula (7-8-1), Z²² are each independently an alkyl group, a cycloalkyl group, or an aryl group; R²² is an alkyl group, a cycloalkyl group, or an alkoxyl group; and r is an integer of 0 to 3.)

Examples of the other acid generating agent include, but not particularly limited to, bissulfonyldiazomethanes such as bis(p-toluenesulfonyl)diazomethane, bis(2,4-dimethylphenylsulfonyl)diazomethane, bis(tert-butylsulfonyl)diazomethane, bis(n-butylsulfonyl)diazomethane, bis(isobutylsulfonyl)diazomethane, bis(isopropylsulfonyl)diazomethane, bis(n-propylsulfonyl)diazomethane, bis(cyclohexylsulfonyl)diazomethane, bis(isopropylsulfonyl)diazomethane, 1,3-bis(cyclohexylsulfonylazomethylsulfonyl)propane, 1,4-bis(phenylsulfonylazomethylsulfonyl)butane, 1,6-bis(phenylsulfonylazomethylsulfonyl)hexane, and 1,10-bis(cyclohexylsulfonylazomethylsulfonyl)decane; and halogen-containing triazine derivatives such as 2-(4-methoxyphenyl)-4,6-(bistrichloromethyl)-1,3,5-triazine, 2-(4-methoxynaphthyl)-4,6-(bistrichloromethyl)-1,3,5-triazine, tris(2,3-dibromopropyl)-1,3,5-triazine, and tris(2,3-dibromopropyl)isocyanurate.

Among the above acid generating agents, an acid generating agent having an aromatic ring is preferable, and an acid generating agent represented by the formula (7-1) or (7-2) is more preferable. An acid generating agent having a sulfonate ion wherein X⁻ of the formula (7-1) or (7-2) has an aryl group or a halogen-substituted aryl group is still more preferable; an acid generating agent having a sulfonate ion wherein X⁻ of the formula (7-1) or (7-2) has an aryl group is particularly preferable; and diphenyltrimethylphenylsulfonium p-toluenesulfonate, triphenylsulfonium p-toluenesulfonate, triphenylsulfonium trifluoromethanesulfonate, and triphenylsulfonium nonafluoromethanesulfonate are particularly preferable. By using the acid generating agent, the radiation-sensitive composition of the present embodiment can reduce LER.

The acid generating agent can be used alone as one kind or in combination of two or more kinds.

### (2) Acid Crosslinking Agent

The radiation-sensitive composition of the present embodiment preferably contains one or more acid crosslinking agents. The acid crosslinking agent is a compound capable of intramolecular or intermolecular crosslinking the compound represented by the above formula (1) (resist base material) in the presence of the acid generated from the acid generating agent. Examples of such an acid crosslinking agent include a compound having one or more groups (hereinafter, referred to as "crosslinkable group") capable of crosslinking the compound represented by the above formula (1) (resist base material).

Specific examples of such a crosslinkable group include, but not particularly limited to, (i) a hydroxyalkyl group such as a hydroxy (C1-C6 alkyl group), a C1-C6 alkoxy (C1-C6 alkyl group), and an acetoxy (C1-C6 alkyl group), or a group derived therefrom; (ii) a carbonyl group such as a formyl group and a carboxy (C1-C6 alkyl group), or a group derived therefrom; (iii) a nitrogenous group-containing group such as a dimethylaminomethyl group, a diethylaminomethyl group, a dimethylolaminomethyl group, a diethylolaminomethyl group, and a morpholinomethyl group; (iv) a glycidyl group-containing group such as a glycidyl ether group, a glycidyl ester group, and a glycidylamino group; (v) a group derived from an aromatic group such as a C1-C6 allyloxy (C1-C6 alkyl group) and a C1-C6 aralkyloxy (C1-C6 alkyl group) such as a benzyloxymethyl group and a benzoyloxymethyl group; and (vi) a polymerizable multiple bond-containing group such as a vinyl group and an isopropenyl group. In the present embodiment, as the crosslinkable group of the acid crosslinking agent, a hydroxyalkyl group and an alkoxyalkyl group or the like are preferable, and an alkoxymethyl group is particularly preferable.

Examples of the acid crosslinking agent having the above crosslinkable group include, but not particularly limited to, (i) a methylol group-containing compound such as a methylol group-containing melamine compound, a methylol group-containing benzoguanamine compound, a methylol group-containing urea compound, a methylol group-containing glycoluryl compound, and a methylol group-containing phenolic compound; (ii) an alkoxyalkyl group-containing compound such as an alkoxyalkyl group-containing melamine compound, an alkoxyalkyl group-containing benzoguanamine compound, an alkoxyalkyl group-containing urea compound, an alkoxyalkyl group-containing glycoluryl compound, and an alkoxyalkyl group-containing phenolic compound; (iii) a carboxymethyl group-containing compound such as a carboxymethyl group-containing melamine compound, a carboxymethyl group-containing benzoguanamine compound, a carboxymethyl group-containing urea compound, a carboxymethyl group-containing glycoluryl compound, and a carboxymethyl group-containing phenolic compound; (iv) an epoxy compound such as a bisphenol A based epoxy compound, a bisphenol F based epoxy compound, a bisphenol S based epoxy compound, a novolac resin based epoxy compound, a resol resin based epoxy compound, and a poly(hydroxystyrene) based epoxy compound.

As the acid crosslinking agent, a compound having a phenolic hydroxyl group, and a compound and resin where the above crosslinkable group is introduced into an acid functional group in an alkali soluble resin to impart crosslinkability can be further used. The introduction rate of the crosslinkable group in that case is adjusted to be usually 5 to 100 mol %, preferably 10 to 60 mol %, and more preferably 15 to 40 mol % based on the total acid functional groups in the compound having a phenolic hydroxyl group, and the alkali soluble resin. When the introduction rate of the crosslinkable group falls within the above range, the crosslinking reaction sufficiently occurs, and a decrease in the film remaining rate, and swelling phenomena and meandering or the like of a pattern are avoided, which is preferable.

In the radiation-sensitive composition of the present embodiment, the acid crosslinking agent is preferably an alkoxyalkylated urea compound or resin thereof, or an alkoxyalkylated glycoluryl compound or resin thereof. Particularly preferable examples of the acid crosslinking agent include compounds represented by the following formulae (8-1) to (8-3) and an alkoxymethylated melamine compound (acid crosslinking agent). 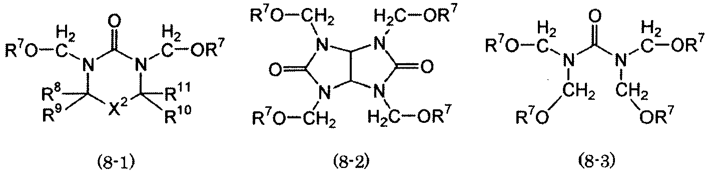 (In the above formulae (8-1) to (8-3), R⁷ each independently represents a hydrogen atom, an alkyl group, or an acyl group; R⁸ to R¹¹ each independently represents a hydrogen atom, a hydroxyl group, an alkyl group, or an alkoxyl group; and X² represents a single bond, a methylene group, or an oxygen atom.)

The alkyl group represented by R⁷ is preferably 1 to 6 carbon atoms, and more preferably 1 to 3 carbon atoms. Examples thereof include a methyl group, an ethyl group, and a propyl group. The acyl group represented by R⁷ is preferably 2 to 6 carbon atoms, and more preferably 2 to 4 carbon atoms. Examples thereof include an acetyl group and a propionyl group. The alkyl group represented by R⁸ to R¹¹ is preferably 1 to 6 carbon atoms, and more preferably 1 to 3 carbon atoms. Examples thereof include a methyl group, an ethyl group, and a propyl group. The alkoxy group represented by R⁸ to R¹¹ is preferably 1 to 6 carbon atoms, and more preferably 1 to 3 carbon atoms. Examples thereof include a methoxy group, an ethoxy group, and a propoxy group. X² is preferably a single bond or a methylene group. R⁷ to R¹¹ and X² may be substituted with an alkyl group such as a methyl group and an ethyl group, an alkoxy group such as a methoxy group and an ethoxy group, a hydroxyl group, and a halogen atom or the like. A plurality of R⁷ and R⁸ to R¹¹ may be each the same or different.

Specific examples of the compound represented by the formula (8-1) can include, but not particularly limited to, compounds shown below:

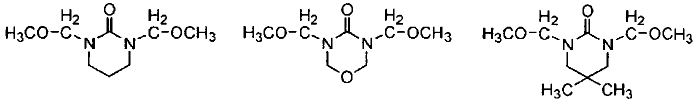

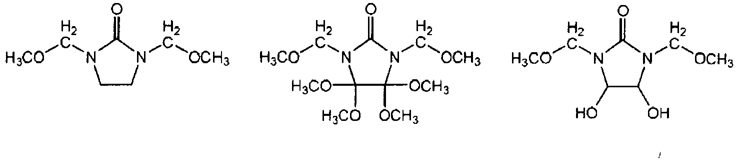

Specific examples of the compound represented by the formula (8-2) include, but not particularly limited to, N,N,N,N-tetra(methoxymethyl)glycoluryl, N,N,N,N-tetra(ethoxymethyl)glycoluryl, N,N,N,N-tetra(n-propoxymethyl)glycoluryl, N,N,N,N-tetra(isopropoxymethyl)glycoluryl, N,N,N,N-tetra(n-butoxymethyl)glycoluryl, and N,N,N,N-tetra(t-butoxymethyl)glycoluryl. Among these, N,N,N,N-tetra(methoxymethyl)glycoluryl is particularly preferable.

Specific examples of the compound represented by the formula (8-3) include, but not particularly limited to, compounds represented below:

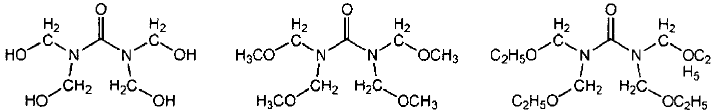

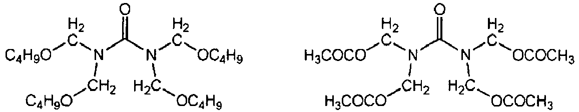

Specific examples of the alkoxymethylated melamine compound include, but not particularly limited to, N,N,N,N,N,N-hexa(methoxymethyl)melamine, N,N,N,N,N,N-hexa(ethoxymethyl)melamine, N,N,N,N,N,N-hexa(n-propoxymethyl)melamine, N,N,N,N,N,N-hexa(isopropoxymethyl)melamine, N,N,N,N,N,N-hexa(n-butoxymethyl)melamine, and N,N,N,N,N,N-hexa(t-butoxymethyl)melamine. Among these, N,N,N,N,N,N-hexa(methoxymethyl)melamine is particularly preferable.

The above acid crosslinking agent (G1) can be obtained by, for example, conducting a condensation reaction of a urea compound or a glycoluryl compound with formalin to introduce a methylol group, etherifying the product with lower alcohols such as methyl alcohol, ethyl alcohol, propyl alcohol, and butyl alcohol, and then cooling the reaction solution to collect a precipitated compound or resin thereof. The above acid crosslinking agent (G1) can be obtained as a commercially available product such as CYMEL (trade name, manufactured by MT AquaPolymer) and NIKALAC (manufactured by Sanwa Chemical).

Other particularly preferable examples of the acid crosslinking agent include a phenol derivative having 1 to 6 benzene rings within a molecule and two or more hydroxyalkyl groups and/or alkoxyalkyl groups within the entire molecule, the hydroxyalkyl groups and/or alkoxyalkyl groups being bonded to any of the above benzene rings. Preferable examples thereof include a phenol derivative having a molecular weight of 1500 or less, 1 to 6 benzene rings and a total of two or more hydroxyalkyl groups and/or alkoxyalkyl groups within a molecule, the hydroxyalkyl groups and/or alkoxyalkyl groups being bonded to any one of the above benzene rings, or a plurality of benzene rings.

The hydroxyalkyl group bonded to a benzene ring is the one of 1 to 6 carbon atoms such as a hydroxymethyl group, a 2-hydroxyethyl group, and a 2-hydroxy-1-propyl group is preferable. As the alkoxyalkyl group bonded to a benzene ring, the one of 2 to 6 carbon atoms is preferable. Specifically, a methoxymethyl group, an ethoxymethyl group, an n-propoxymethyl group, an isopropoxymethyl group, an n-butoxymethyl group, an isobutoxymethyl group, a sec-butoxymethyl group, a t-butoxymethyl group, a 2-methoxyethyl group, or a 2-methoxy-1-propyl group is preferable.

Among these phenol derivatives, particularly preferable ones are shown below:

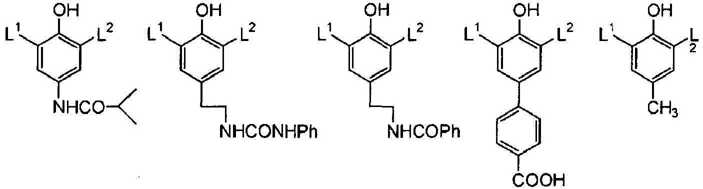

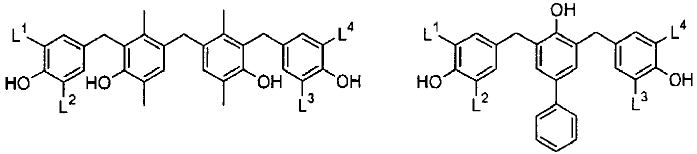

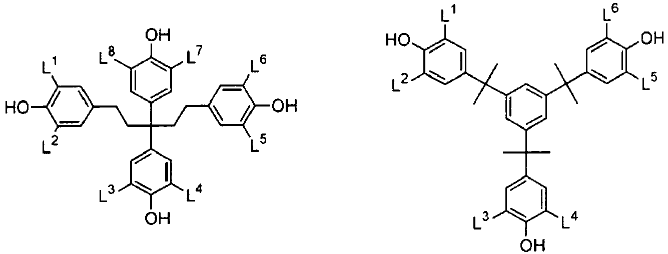

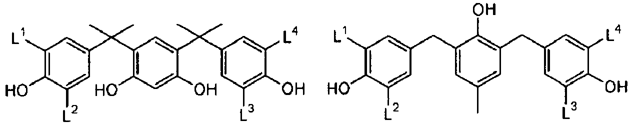

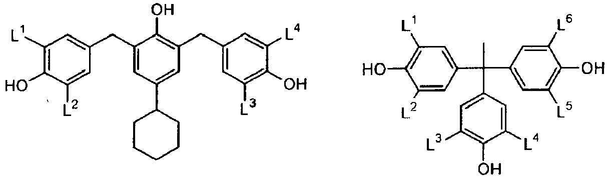

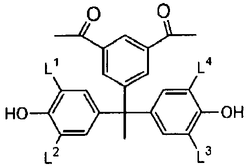

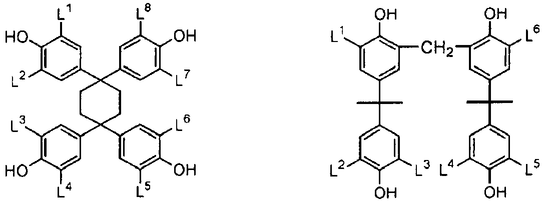

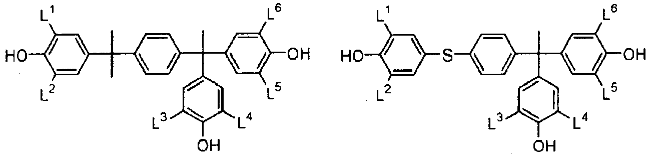

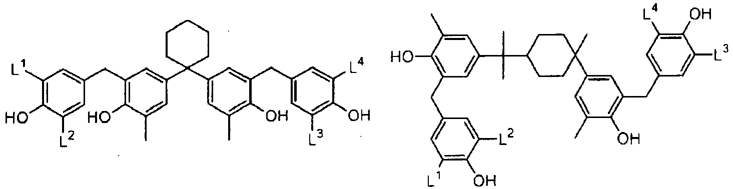

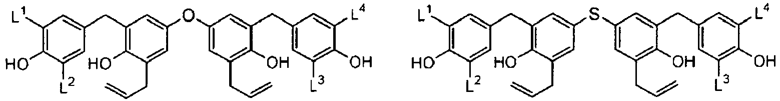

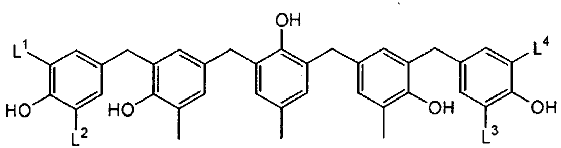

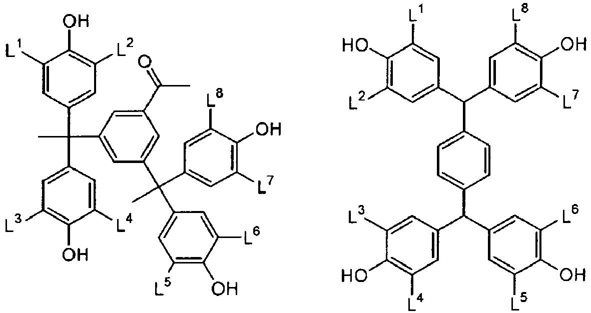

In the above formulae, L¹ to L⁸ may be the same or different, and each independently represents a hydroxymethyl group, a methoxymethyl group, or an ethoxymethyl group. A phenol derivative having a hydroxymethyl group can be obtained by reacting the corresponding phenolic compound having no hydroxymethyl group (a compound where L¹ to L⁸ in the above formulae are a hydrogen atom) with formaldehyde in the presence of a basic catalyst. In this case, in order to prevent resinification and gelation, the reaction temperature is preferably 60°C or less. Specifically, it can be synthesized by methods described in Japanese Patent Application Laid-Open Nos. 6-282067 and 7-64285 or the like.

A phenol derivative having an alkoxymethyl group can be obtained by reacting the corresponding phenol derivative having a hydroxymethyl group with an alcohol in the presence of an acid catalyst. In this case, in order to prevent resinification and gelation, the reaction temperature is preferably 100°C or less. Specifically, it can be synthesized by methods described in EP632003A1 or the like.

While the phenol derivative having a hydroxymethyl group and/or an alkoxymethyl group thus synthesized is preferable in terms of stability upon storage, the phenol derivative having an alkoxymethyl group is particularly preferable in terms of stability upon storage. The acid crosslinking agent may be used alone, or may be used in combination of two or more kinds.

Other particularly preferable examples of the acid crosslinking agent include a compound having at least one α-hydroxyisopropyl group. The compound is not particularly limited in the structure, as long as it has an α-hydroxyisopropyl group. A hydrogen atom of a hydroxyl group in the above α-hydroxyisopropyl group may be substituted with one or more acid dissociation groups (R-COO- group, R-SO₂- group or the like, wherein R represents a substituent group selected from the group consisting of a linear hydrocarbon group of 1 to 12 carbon atoms, a cyclic hydrocarbon group of 3 to 12 carbon atoms, an alkoxy group of 1 to 12 carbon atoms, a 1-branched alkyl group of 3 to 12 carbon atoms, and an aromatic hydrocarbon group of 6 to 12 carbon atoms). Examples of a compound having the above α-hydroxyisopropyl group include one kind or two kinds or more of a substituted or non-substituted aromatic based compound, a diphenyl compound, a naphthalene compound, a furan compound or the like containing at least one α-hydroxyisopropyl group. Specific examples thereof include a compound represented by the following general formula (9-1) (hereinafter, referred to as "benzene based compound (1)"), a compound represented by the following general formula (9-2) (hereinafter, referred to as "diphenyl based compound (2)"), a compound represented by the following general formula (9-3) (hereinafter, referred to as "naphthalene based compound (3)"), and a compound represented by the following general formula (9-4) (hereinafter, referred to as "furan based compound (4)") .

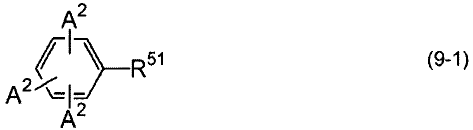

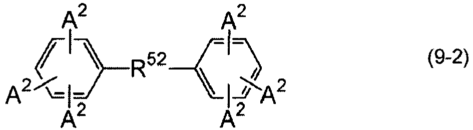

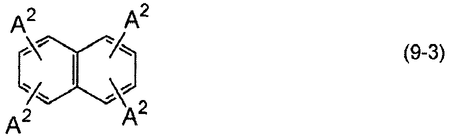

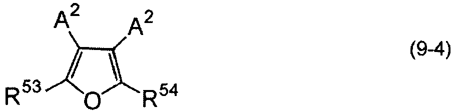

In the above general formulae (9-1) to (9-4), each A² independently represents an α-hydroxyisopropyl group or a hydrogen atom, and at least one A² is an α-hydroxyisopropyl group. In the general formula (9-1), R⁵¹ represents a hydrogen atom, a hydroxyl group, a linear or branched alkylcarbonyl group of 2 to 6 carbon atoms, or a linear or branched alkoxycarbonyl group of 2 to 6 carbon atoms. Furthermore, in the general formula (9-2), R⁵² represents a single bond, a linear or branched alkylene group of 1 to 5 carbon atoms, -O-, -CO-, or -COO-. Also, in the general formula (9-4), R⁵³ and R⁵⁴ represent a hydrogen atom or a linear or branched alkyl group of 1 to 6 carbon atoms independently from each other.

Specific examples of the benzene based compound (1) include, but not particularly limited to, α-hydroxyisopropylbenzenes such as α-hydroxyisopropylbenzene, 1,3-bis(α-hydroxyisopropyl)benzene, 1,4-bis(α-hydroxyisopropyl)benzene, 1,2,4-tris(α-hydroxyisopropyl)benzene, and 1,3,5-tris(α-hydroxyisopropyl)benzene; α-hydroxyisopropylphenols such as 3-α-hydroxyisopropylphenol, 4-α-hydroxyisopropylphenol, 3,5-bis(α-hydroxyisopropyl)phenol, and 2,4,6-tris(α-hydroxyisopropyl)phenol; α-hydroxyisopropylphenyl alkyl ketones such as 3-α-hydroxyisopropylphenyl methyl ketone, 4-α-hydroxyisopropylphenyl methyl ketone, 4-α-hydroxyisopropylphenyl ethyl ketone, 4-α-hydroxyisopropylphenyl-n-propyl ketone, 4-α-hydroxyisopropylphenyl isopropyl ketone, 4-α-hydroxyisopropylphenyl-n-butyl ketone, 4-α-hydroxyisopropylphenyl-t-butyl ketone, 4-α-hydroxyisopropylphenyl-n-pentyl ketone, 3,5-bis(α-hydroxyisopropyl)phenyl methyl ketone, 3,5-bis(α-hydroxyisopropyl)phenyl ethyl ketone, and 2,4,6-tris(α-hydroxyisopropyl)phenyl methyl ketone; alkyl 4-α-hydroxyisopropylbenzoates such as methyl 3-α-hydroxyisopropylbenzoate, methyl 4-α-hydroxyisopropylbenzoate, ethyl 4-α-hydroxyisopropylbenzoate, n-propyl 4-α-hydroxyisopropylbenzoate, isopropyl 4-α-hydroxyisopropylbenzoate, n-butyl 4-α-hydroxyisopropylbenzoate, t-butyl 4-α-hydroxyisopropylbenzoate, n-pentyl 4-α-hydroxyisopropylbenzoate, methyl 3,5-bis(α-hydroxyisopropyl)benzoate, ethyl 3,5-bis(α-hydroxyisopropyl)benzoate, and methyl 2,4,6-tris(α-hydroxyisopropyl)benzoate.

Specific examples of the above diphenyl based compound (2) include, but not particularly limited to, α-hydroxyisopropylbiphenyls such as 3-α-hydroxyisopropylbiphenyl, 4-α-hydroxyisopropylbiphenyl, 3,5-bis(α-hydroxyisopropyl)biphenyl, 3,3'-bis(α-hydroxyisopropyl)biphenyl, 3,4'-bis(α-hydroxyisopropyl)biphenyl, 4,4'-bis(α-hydroxyisopropyl)biphenyl, 2,4,6-tris(α-hydroxyisopropyl)biphenyl, 3,3',5-tris(α-hydroxyisopropyl)biphenyl, 3,4',5-tris(α-hydroxyisopropyl)biphenyl, 2,3',4,6,-tetrakis(α-hydroxyisopropyl)biphenyl, 2,4,4',6,-tetrakis(α-hydroxyisopropyl)biphenyl, 3,3',5,5'-tetrakis(α-hydroxyisopropyl)biphenyl, 2,3',4,5',6-pentakis(α-hydroxyisopropyl)biphenyl, and 2,2',4,4',6,6'-hexakis(α-hydroxyisopropyl)biphenyl; α-hydroxyisopropyldiphenylalkanes such as 3-α-hydroxyisopropyldiphenylmethane, 4-α-hydroxyisopropyldiphenylmethane, 1-(4-α-hydroxyisopropylphenyl)-2-phenylethane, 1-(4-α-hydroxyisopropylphenyl)-2-phenylpropane, 2-(4-α-hydroxyisopropylphenyl)-2-phenylpropane, 1-(4-α-hydroxyisopropylphenyl)-3-phenylpropane, 1-(4-α-hydroxyisopropylphenyl)-4-phenylbutane, 1-(4-α-hydroxyisopropylphenyl)-5-phenylpentane, 3,5-bis(α-hydroxyisopropyldiphenylmethane, 3,3'-bis(α-hydroxyisopropyl)diphenylmethane, 3,4'-bis(α-hydroxyisopropyl)diphenylmethane, 4,4'-bis(α-hydroxyisopropyl)diphenylmethane, 1,2-bis(4-α-hydroxyisopropylphenyl)ethane, 1,2-bis(4-α-hydroxypropylphenyl)propane, 2,2-bis(4-α-hydroxypropylphenyl)propane, 1,3-bis(4-α-hydroxypropylphenyl)propane, 2,4,6-tris(α-hydroxyisopropyl)diphenylmethane, 3,3',5-tris(α-hydroxyisopropyl)diphenylmethane, 3,4',5-tris(α-hydroxyisopropyl)diphenylmethane, 2,3',4,6-tetrakis(α-hydroxyisopropyl)diphenylmethane, 2,4,4',6-tetrakis(α-hydroxyisopropyl)diphenylmethane, 3,3',5,5'-tetrakis(α-hydroxyisopropyl)diphenylmethane, 2,3',4,5',6-pentakis(α-hydroxyisopropyl)diphenylmethane, and 2,2',4,4',6,6'-hexakis(a-hydroxyisopropyl)diphenylmethane; α-hydroxyisopropyldiphenyl ethers such as 3-α-hydroxyisopropyldiphenyl ether, 4-α-hydroxyisopropyldiphenyl ether, 3,5-bis(α-hydroxyisopropyl)diphenyl ether, 3,3'-bis(α-hydroxyisopropyl)diphenyl ether, 3,4'-bis(α-hydroxyisopropyl)diphenyl ether, 4,4'-bis(α-hydroxyisopropyl)diphenyl ether, 2,4,6-tris(α-hydroxyisopropyl)diphenyl ether, 3,3',5-tris(α-hydroxyisopropyl)diphenyl ether, 3,4',5-tris(α-hydroxyisopropyl)diphenyl ether, 2,3',4,6-tetrakis(α-hydroxyisopropyl)diphenyl ether, 2,4,4',6-tetrakis(α-hydroxyisopropyl)diphenyl ether, 3,3',5,5'-tetrakis(α-hydroxyisopropyl)diphenyl ether, 2,3',4,5',6-pentakis(α-hydroxyisopropyl)diphenyl ether, and 2,2',4,4',6,6'-hexakis(α-hydroxyisopropyl)diphenyl ether; α-hydroxyisopropyldiphenyl ketones such as 3-α-hydroxyisopropyldiphenyl ketone, 4-α-hydroxyisopropyldiphenyl ketone, 3,5-bis(α-hydroxyisopropyl)diphenyl ketone, 3,3'-bis(α-hydroxyisopropyl)diphenyl ketone, 3,4'-bis(α-hydroxyisopropyl)diphenyl ketone, 4,4'-bis(α-hydroxyisopropyl)diphenyl ketone, 2,4,6-tris(α-hydroxyisopropyl)diphenyl ketone, 3,3',5-tris(α-hydroxyisopropyl)diphenyl ketone, 3,4',5-tris(α-hydroxyisopropyl)diphenyl ketone, 2,3',4,6-tetrakis(α-hydroxyisopropyl)diphenyl ketone, 2,4,4',6-tetrakis(α-hydroxyisopropyl)diphenyl ketone, 3,3',5,5'-tetrakis(α-hydroxyisopropyl)diphenyl ketone, 2,3',4,5',6-pentakis(α-hydroxyisopropyl)diphenyl ketone, and 2,2',4,4',6,6'-hexakis(α-hydroxyisopropyl)diphenyl ketone; phenyl α-hydroxyisopropylbenzoates such as phenyl 3-α-hydroxyisopropylbenzoate, phenyl 4-α-hydroxyisopropylbenzoate, 3-α-hydroxyisopropylphenyl benzoate, 4-α-hydroxyisopropylphenyl benzoate, phenyl 3,5-bis(-αhydroxyisopropyl)benzoate, 3-α-hydroxyisopropylphenyl 3-α-hydroxyisopropylbenzoate, 4-α-hydroxyisopropylphenyl 3-α-hydroxyisopropylbenzoate, 3-α-hydroxyisopropylphenyl 4-α-hydroxyisopropylbenzoate, 4-α-hydroxyisopropylphenyl 4-α-hydroxyisopropylbenzoate, 3,5-bis(α-hydroxyisopropyl)phenyl benzoate, phenyl 2,4,6-tris(α-hydroxyisopropyl)benzoate, 3-α-hydroxyisopropylphenyl 3,5-bis(α-hydroxyisopropyl)benzoate, 4-α-hydroxyisopropylphenyl 3,5-bis(α-hydroxyisopropyl)benzoate, 3,5-bis(α-hydroxyisopropyl)phenyl 3-α-hydroxyisopropylbenzoate, 3,5-bis(α-hydroxyisopropyl)phenyl 4-α-hydroxyisopropylbenzoate, 2,4,6-tris(α-hydroxyisopropyl)phenyl benzoate, 3-α-hydroxyisopropylphenyl 2,4,6-tris(α-hydroxyisopropyl)benzoate, 4-α-hydroxyisopropylphenyl 2,4,6-tris(a-hydroxyisopropyl)benzoate, 3,5-bis(α-hydroxyisopropyl)phenyl 3,5-bis(α-hydroxyisopropyl)benzoate, 2,4,6-tris(α-hydroxyisopropyl)phenyl 3-α-hydroxyisopropylbenzoate, 2,4,6-tris(α-hydroxyisopropyl)phenyl 4-α-hydroxyisopropylbenzoate, 3,5-bis(α-hydroxyisopropyl)phenyl 2,4,6-tris(α-hydroxyisopropyl)benzoate, 2,4,6-tris(α-hydroxyisopropyl)phenyl 3,5-bis(α-hydroxyisopropyl)benzoate, and 2,4,6-tris(α-hydroxyisopropyl)phenyl 2,4,6-tris(α-hydroxyisopropyl)benzoate.

Furthermore, specific examples of the above naphthalene based compound (3) include, but not particularly limited to, 1-(α-hydroxyisopropyl)naphthalene, 2-(α-hydroxyisopropyl)naphthalene, 1,3-bis(α-hydroxyisopropyl)naphthalene, 1,4-bis(α-hydroxyisopropyl)naphthalene, 1,5-bis(α-hydroxyisopropyl)naphthalene, 1,6-bis(α-hydroxyisopropyl)naphthalene, 1,7-bis(α-hydroxyisopropyl)naphthalene, 2,6-bis(α-hydroxyisopropyl)naphthalene, 2,7-bis(α-hydroxyisopropyl)naphthalene, 1,3,5-tris(α-hydroxyisopropyl)naphthalene, 1,3,6-tris(α-hydroxyisopropyl)naphthalene, 1,3,7-tris(α-hydroxyisopropyl)naphthalene, 1,4,6-tris(α-hydroxyisopropyl)naphthalene, 1,4,7-tris(α-hydroxyisopropyl)naphthalene, and 1,3,5,7-tetrakis(α-hydroxyisopropyl)naphthalene.

Specific examples of the above furan based compound (4) include, but not particularly limited to, 3-(α-hydroxyisopropyl)furan, 2-methyl-3-(α-hydroxyisopropyl)furan, 2-methyl-4-(α-hydroxyisopropyl)furan, 2-ethyl-4-(α-hydroxyisopropyl)furan, 2-n-propyl-4-(α-hydroxyisopropyl)furan, 2-isopropyl-4-(α-hydroxyisopropyl)furan, 2-n-butyl-4-(α-hydroxyisopropyl)furan, 2-t-butyl-4-(α-hydroxyisopropyl)furan, 2-n-pentyl-4-(α-hydroxyisopropyl)furan, 2,5-dimethyl-3-(α-hydroxyisopropyl)furan, 2,5-diethyl-3-(α-hydroxyisopropyl)furan, 3,4-bis(α-hydroxyisopropyl)furan, 2,5-dimethyl-3,4-bis(α-hydroxyisopropyl)furan, and 2,5-diethyl-3,4-bis(α-hydroxyisopropyl)furan.

As the above acid crosslinking agent, a compound having two or more free α-hydroxyisopropyl groups is preferable; the above benzene based compound (1) having two or more α-hydroxyisopropyl groups, the above diphenyl based compound (2) having two or more α-hydroxyisopropyl groups, and the above naphthalene based compound (3) having two or more α-hydroxyisopropyl groups are more preferable; and α-hydroxyisopropylbiphenyls having two or more α-hydroxyisopropyl groups and the above naphthalene based compound (3) having two or more α-hydroxyisopropyl groups are particularly preferable.

The above acid crosslinking agent can normally be obtained by a method for reacting an acetyl group-containing compound such as 1,3-diacetylbenzene with Grignard reagent such as CH₃MgBr to methylate and then hydrolyzing, or a method for oxidizing an isopropyl group-containing compound such as 1,3-diisopropylbenzene with oxygen or the like to produce a peroxide and then reducing.

The amount of the acid crosslinking agent used in the radiation-sensitive composition of the present embodiment is preferably 0.5 to 49% by mass of the total weight of the solid component, more preferably 0.5 to 40% by mass, still more preferably 1 to 30% by mass, and particularly preferably 2 to 20% by mass. When the content ratio of the above acid crosslinking agent is 0.5% by mass or more, the radiation-sensitive composition of the present embodiment improves the inhibiting effect of the solubility of a resist film in an alkaline developing solution, and can inhibit a decrease in the film remaining rate, and occurrence of swelling and meandering of a pattern, which is preferable. On the other hand, when the content ratio of the above acid crosslinking agent is 50% by mass or less, the radiation-sensitive composition of the present embodiment can inhibit a decrease in heat resistance as a resist, which is preferable.

The content of at least one kind of compound in the above acid crosslinking agent is also not particularly limited, and can be within various ranges according to the kind of substrates or the like used upon forming a resist pattern.

In all acid crosslinking agent components, preferably, the content of the alkoxymethylated melamine compound and/or the compounds represented by the formulae (9-1) to (9-3) is 50 to 99% by mass, preferably 60 to 99% by mass, more preferably 70 to 98% by mass, and still more preferably 80 to 97% by mass. By having the alkoxymethylated melamine compound and/or the compounds represented by the formulae (9-1) to (9-3) of 50% by mass or more of all acid crosslinking agent components, the radiation-sensitive composition of the present embodiment can improve the resolution, which is preferable. By having the compounds of 99% by mass or less, the pattern cross section is more likely to have a rectangular shape, which is preferable.

### 3. Acid Diffusion Controlling Agent

The radiation-sensitive composition of the present embodiment may contain an acid diffusion controlling agent having a function of controlling diffusion of an acid generated from an acid generating agent by radiation irradiation in a resist film to inhibit any unpreferable chemical reaction in an unexposed region or the like. By using such an acid diffusion controlling agent, the storage stability of a radiation-sensitive composition improves. Also, along with the improvement of the resolution, the line width change of a resist pattern due to variation in the post exposure delay time before radiation irradiation and the post exposure delay time after radiation irradiation can be inhibited, and the composition has extremely excellent process stability. Examples of such an acid diffusion controlling agent includes, but not particularly limited to, a radiation degradable basic compound such as a nitrogen atom-containing basic compound, a basic sulfonium compound, and a basic iodonium compound. The acid diffusion controlling agent can be used alone or in combination of two or more kinds.

Examples of the above acid diffusion controlling agent include, but not particularly limited to, a nitrogen-containing organic compound, and a basic compound degradable by exposure. Examples of the above nitrogen-containing organic compound include, but not particularly limited to, a compound represented by the following general formula (10): 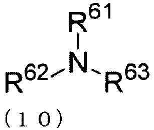 (hereinafter, referred to as a "nitrogen-containing compound (I)"), a diamino compound having two nitrogen atoms within the same molecule (hereinafter, referred to as a "nitrogen-containing compound (II)"), a polyamino compound or polymer having three or more nitrogen atoms (hereinafter, referred to as a "nitrogen-containing compound (III)"), an amide group-containing compound, a urea compound, and a nitrogen-containing heterocyclic compound. The acid diffusion controlling agent (E) may be used alone as one kind or may be used in combination of two or more kinds.

In the above general formula (10), R⁶¹, R⁶², and R⁶³ represent a hydrogen atom, a linear, branched or cyclic alkyl group, an aryl group, or an aralkyl group independently from each other. The above alkyl group, aryl group, or aralkyl group may be non-substituted or may be substituted with a hydroxyl group or the like. Herein, examples of the above linear, branched or cyclic alkyl group include the one of 1 to 15 carbon atoms, and preferably 1 to 10 carbon atoms. Specific examples thereof include a methyl group, an ethyl group, an n-propyl group, an isopropyl group, an n-butyl group, an isobutyl group, a sec-butyl group, a t-butyl group, an n-pentyl group, a neopentyl group, an n-hexyl group, a texyl group, an n-heptyl group, an n-octyl group, an n-ethylhexyl group, an n-nonyl group, and an n-decyl group. Examples of the above aryl group include the one of 6 to 12 carbon atoms. Specific examples thereof include a phenyl group, a tolyl group, a xylyl group, a cumenyl group, and a 1-naphthyl group. Furthermore, examples of the above aralkyl group include the one of 7 to 19 carbon atoms, and preferably 7 to 13 carbon atoms. Specific examples thereof include a benzyl group, an α-methylbenzyl group, a phenethyl group, and a naphthylmethyl group.

Specific examples of the above nitrogen-containing compound (I) include, but not particularly limited to, mono(cyclo)alkylamines such as n-hexylamine, n-heptylamine, n-octylamine, n-nonylamine, n-decylamine, n-dodecylamine, and cyclohexylamine; di(cyclo)alkylamines such as di-n-butylamine, di-n-pentylamine, di-n-hexylamine, di-n-heptylamine, di-n-octylamine, di-n-nonylamine, di-n-decylamine, methyl-n-dodecylamine, di-n-dodecylmethyl, cyclohexylmethylamine, and dicyclohexylamine; tri(cyclo)alkylamines such as triethylamine, tri-n-propylamine, tri-n-butylamine, tri-n-pentylamine, tri-n-hexylamine, tri-n-heptylamine, tri-n-octylamine, tri-n-nonylamine, tri-n-decylamine, dimethyl-n-dodecylamine, di-n-dodecylmethylamine, dicyclohexylmethylamine, and tricyclohexylamine; alkanolamines such as monoethanolamine, diethanolamine, and triethanolamine; and aromatic amines such as aniline, N-methylaniline, N,N-dimethylaniline, 2-methylaniline, 3-methylaniline, 4-methylaniline, 4-nitroaniline, diphenylamine, triphenylamine, and 1-naphthylamine.

Specific examples of the above nitrogen-containing compound (II) include, but not particularly limited to, ethylenediamine, N,N,N',N'-tetramethylethylenediamine, N,N,N',N'-tetrakis(2-hydroxypropyl)ethylenediamine, tetramethylenediamine, hexamethylenediamine, 4,4'-diaminodiphenylmethane, 4,4'-diaminodiphenyl ether, 4,4'-diaminobenzophenone, 4,4'-diaminodiphenylamine, 2,2-bis(4-aminophenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis[1-(4-aminophenyl)-1-methylethyl]benzene, and 1,3-bis[1-(4-aminophenyl)-1-methylethyl]benzene.

Specific examples of the above nitrogen-containing compound (III) include, but not particularly limited to, polymers of polyethyleneimine, polyarylamine, and N-(2-dimethylaminoethyl)acrylamide.

Specific examples of the above amide group-containing compound include, but not particularly limited to, formamide, N-methylformamide, N,N-dimethylformamide, acetamide, N-methylacetamide, N,N-dimethylacetamide, propioneamide, benzamide, pyrrolidone, and N-methylpyrrolidone.

Specific examples of the above urea compound include, but not particularly limited to, urea, methylurea, 1,1-dimethylurea, 1,3-dimethylurea, 1,1,3,3-tetramethylurea, 1,3-diphenylurea, and tri-n-butylthiourea.

Specific examples of the above nitrogen-containing heterocyclic compound include, but not particularly limited to, imidazoles such as imidazole, benzimidazole, 4-methylimidazole, 4-methyl-2-phenylimidazole, and 2-phenylbenzimidazole; pyridines such as pyridine, 2-methylpyridine, 4-methylpyridine, 2-ethylpyridine, 4-ethylpyridine, 2-phenylpyridine, 4-phenylpyridine, 2-methyl-4-phenylpyridine, nicotine, nicotinic acid, amide nicotinate, quinoline, 8-oxyquinoline, and acridine; and pyrazine, pyrazole, pyridazine, quinozaline, purine, pyrrolidine, piperidine, morpholine, 4-methylmorpholine, piperazine, 1,4-dimethylpiperazine, and 1,4-diazabicyclo[2.2.2] octane.

Examples of the radiation degradable basic compound can include, but not particularly limited to, a sulfonium compound represented by the following general formula (11-1) : 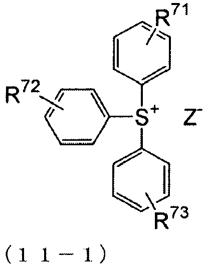 and an iodonium compound represented by the following general formula (11-2):

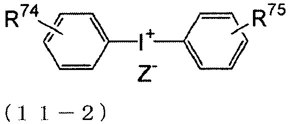

In the above general formulae (11-1) and (11-2), R⁷¹, R⁷², R⁷³, R⁷⁴, and R⁷⁵ represent a hydrogen atom, an alkyl group of 1 to 6 carbon atoms, an alkoxyl group of 1 to 6 carbon atoms, a hydroxyl group, or a halogen atom independently from each other. Z⁻ represents HO⁻, R-COO⁻ (R represents an alkyl group of 1 to 6 carbon atoms, an aryl group of 6 to 11 carbon atoms, or an alkaryl group of 7 to 12 carbon atoms), or an anion represented by the following general formula (11-3):

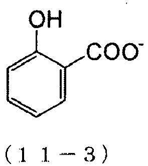

Specific examples of the above radiation degradable basic compound include, but not particularly limited to, triphenylsulfonium hydroxide, triphenylsulfonium acetate, triphenylsulfonium salicylate, diphenyl-4-hydroxyphenylsulfonium hydroxide, diphenyl-4-hydroxyphenylsulfonium acetate, diphenyl-4-hydroxyphenylsulfonium salicylate, bis(4-t-butylphenyl)iodonium hydroxide, bis(4-t-butylphenyl)iodonium acetate, bis(4-t-butylphenyl)iodonium hydroxide, bis(4-t-butylphenyl)iodonium acetate, bis(4-t-butylphenyl)iodonium salicylate, 4-t-butylphenyl-4-hydroxyphenyliodonium hydroxide, 4-t-butylphenyl-4-hydroxyphenyliodonium acetate, and 4-t-butylphenyl-4-hydroxyphenyliodonium salicylate.

In the radiation-sensitive composition of the present embodiment, the content of the acid diffusion controlling agent is preferably 0.001 to 49% by mass of the total weight of the solid component, more preferably 0.01 to 10% by mass, still more preferably 0.01 to 5% by mass, and particularly preferably 0.01 to 3% by mass. When the content of the acid diffusion controlling agent falls within the above range, the radiation-sensitive composition of the present embodiment can prevent a decrease in resolution, and deterioration of the pattern shape and the dimension fidelity or the like. Moreover, even though the post exposure delay time from electron beam irradiation to heating after radiation irradiation becomes longer, the shape of the pattern upper layer portion is not deteriorated. When the content of the acid diffusion controlling agent is 10% by mass or less, the radiation-sensitive composition of the present embodiment can prevent a decrease in sensitivity, and developability of the unexposed portion or the like. By using such an acid diffusion controlling agent, the storage stability of a radiation-sensitive composition improves. Also, along with improvement of the resolution, the line width change of a resist pattern due to variation in the post exposure delay time before radiation irradiation and the post exposure delay time after radiation irradiation can be inhibited, and the composition has extremely excellent process stability.

### (4) Dissolution Promoting Agent

A low molecular weight dissolution promoting agent is a component having a function of increasing the solubility of a compound represented by the above formula (1) (resist base material) in a developing solution to moderately increase the dissolution rate of the resist base material upon developing, when the solubility of the resist base material is too low. The low molecular weight dissolution promoting agent can be used within the range of not deteriorating the effect of the present invention. Examples of the above dissolution promoting agent include, but not particularly limited to, a low molecular weight phenolic compound, for example, bisphenols and tris(hydroxyphenyl)methane. These dissolution promoting agents can be used alone or in mixture of two or more kinds. In the radiation-sensitive composition of the present embodiment, the content of the dissolution promoting agent, which is arbitrarily adjusted according to the kind of the compound represented by the above formula (1) to be used, is preferably 0 to 49% by mass of the total weight of the solid component, more preferably 0 to 5% by mass, still more preferably 0 to 1% by mass, and particularly preferably 0% by mass.

### (5) Dissolution Controlling Agent

The dissolution controlling agent is a component having a function of controlling the solubility of the compound represented by the above formula (1) (resist base material) in a developing solution to moderately decrease the dissolution rate upon developing, when the solubility of the resist base material is too high. As such a dissolution controlling agent, the one which does not chemically change in steps such as calcination of resist coating, radiation irradiation, and development is preferable.

Examples of the dissolution controlling agent include, but not particularly limited to, aromatic hydrocarbons such as phenanthrene, anthracene, and acenaphthene; ketones such as acetophenone, benzophenone, and phenyl naphtyl ketone; and sulfones such as methyl phenyl sulfone, diphenyl sulfone, and dinaphthyl sulfone. These dissolution controlling agents can be used alone or in two or more kinds.

In the radiation-sensitive composition of the present embodiment, the content of the dissolution controlling agent, which is arbitrarily adjusted according to the kind of the compound represented by the above formula (1) to be used, is preferably 0 to 49% by mass of the total weight of the solid component, more preferably 0 to 5% by mass, still more preferably 0 to 1% by mass, and particularly preferably 0% by mass.

### (6) Sensitizing Agent

The sensitizing agent is a component having a function of absorbing irradiated radiation energy, transmitting the energy to the acid generating agent, and thereby increasing the acid production amount, and improving the apparent sensitivity of a resist. Examples of such a sensitizing agent include, but not particularly limited to, benzophenones, biacetyls, pyrenes, phenothiazines, and fluorenes. These sensitizing agents can be used alone or in two or more kinds. In the radiation-sensitive composition of the present embodiment, the content of the sensitizing agent, which is arbitrarily adjusted according to the kind of the compound represented by the above formula (1) to be used, is preferably 0 to 49% by mass of the total weight of the solid component, more preferably 0 to 5% by mass, still more preferably 0 to 1% by mass, and particularly preferably 0% by mass.

### (7) Surfactant

The surfactant is a component having a function of improving coatability and striation of the radiation-sensitive composition of the present embodiment, and developability of a resist or the like. Such a surfactant may be any of anionic, cationic, nonionic or amphoteric. A preferable surfactant is a nonionic surfactant. The nonionic surfactant has a good affinity with a solvent used in production of radiation-sensitive compositions and more effects. Examples of the nonionic surfactant include, but not particularly limited to, a polyoxyethylene higher alkyl ethers, polyoxyethylene higher alkyl phenyl ethers, and higher fatty acid diesters of polyethylene glycol. Examples of commercially available products include, but not particularly limited to, hereinafter by trade name, EFTOP (manufactured by Jemco Inc.), MEGAFAC (manufactured by DIC Corporation), Fluorad (manufactured by Sumitomo 3M Limited), AsahiGuard, Surflon (hereinbefore, manufactured by Asahi Glass Co., Ltd.), Pepole (manufactured by Toho Chemical Industry Co., Ltd.), KP (manufactured by Shin-Etsu Chemical Co., Ltd.), and Polyflow (manufactured by Kyoeisha Chemical Co., Ltd.). In the radiation-sensitive composition of the present embodiment, the content of the surfactant, which is arbitrarily adjusted according to the kind of the compound represented by the above formula (1) to be used, is preferably 0 to 49% by mass of the total weight of the solid component, more preferably 0 to 5% by mass, still more preferably 0 to 1% by mass, and particularly preferably 0% by mass.

### (8) Organic Carboxylic Acid or Oxo Acid of Phosphor or Derivative Thereof

For the purpose of prevention of sensitivity deterioration or improvement of a resist pattern shape and post exposure delay stability or the like, the radiation-sensitive composition of the present embodiment may contain an organic carboxylic acid or an oxo acid of phosphor or derivative thereof as an additional optional component (D). The composition can be used in combination with the acid diffusion controlling agent, or may be used alone. The organic carboxylic acid is not particularly limited but, for example, malonic acid, citric acid, malic acid, succinic acid, benzoic acid, and salicylic acid are preferable. Examples of the oxo acid of phosphor or derivative thereof include phosphoric acid or derivative thereof such as ester including phosphoric acid, di-n-butyl ester phosphate, and diphenyl ester phosphate; phosphonic acid or derivative thereof such as ester including phosphonic acid, dimethyl ester phosphonate, di-n-butyl ester phosphonate, phenylphosphonic acid, diphenyl ester phosphonate, and dibenzyl ester phosphonate; and phosphinic acid and derivative thereof such as ester including phosphinic acid and phenylphosphinic acid. Among these, phosphonic acid is particularly preferable.

The organic carboxylic acid or the oxo acid of phosphor or derivative thereof can be used alone or in combination of two or more kinds. In the radiation-sensitive composition of the present embodiment, the content of the organic carboxylic acid or the oxo acid of phosphor or derivative thereof, which is arbitrarily adjusted according to the kind of the compound represented by the above formula (1) to be used, is preferably 0 to 49% by mass of the total weight of the solid component, more preferably 0 to 5% by mass, still more preferably 0 to 1% by mass, and particularly preferably 0% by mass.

### (9) Other Additive Agent Excluding Above Dissolution Controlling Agent, Sensitizing Agent, Surfactant and Organic Carboxylic Acid or Oxo Acid of Phosphor, or Derivative Thereof

Furthermore, the radiation-sensitive composition of the present embodiment can contain one kind or two kinds or more of additive agents other than the above dissolution controlling agent, sensitizing agent, and surfactant, within the range of not inhibiting the purpose of the present invention, if required. Examples of such an additive agent include a dye, a pigment, and an adhesion aid. For example, the composition contains the dye or the pigment, and thereby a latent image of the exposed portion can be visualized and influence of halation upon exposure can be alleviated, which is preferable. The composition contains the adhesion aid, and thereby adhesiveness to a substrate can be improved, which is preferable. Furthermore, examples of other additive agents can include, but not particularly limited to, a halation preventing agent, a storage stabilizing agent, a defoaming agent, and a shape improving agent. Specific examples thereof can include 4-hydroxy-4'-methylchalkone.

In the radiation-sensitive composition of the present embodiment, the total amount of the optional component (D) is 0 to 99% by mass of the total weight of the solid component, preferably 0 to 49% by mass, more preferably 0 to 10% by mass, still more preferably 0 to 5% by mass, and particularly preferably 0% by mass.

In the radiation-sensitive composition of the present embodiment, the content ratio of each component (the resist base material (A)/the optically active diazonaphthoquinone compound (B)/the optional component (D)) is 1 to 99/99 to 1/0 to 98 in % by mass based on the solid component, preferably 5 to 95/95 to 5/0 to 49, more preferably 10 to 90/90 to 10/0 to 10, still more preferably 20 to 80/80 to 20/0 to 5, and particularly preferably 25 to 75/75 to 25/0. The content ratio of each component is selected from each range so that the summation thereof is 100% by mass. When the content ratio of each component falls within the above range, the radiation-sensitive composition of the present embodiment is excellent in roughness as well as performance such as sensitivity and resolution.

The radiation-sensitive composition of the present embodiment can contain a resin within the range of not inhibiting the purpose of the present invention. The resin includes, but not particularly limited to, a novolac resin, polyvinyl phenols, polyacrylic acid, polyvinyl alcohol, a styrene-maleic anhydride resin, and a polymer containing an acrylic acid, vinyl alcohol, or vinylphenol as a monomeric unit, or derivative thereof. In the radiation-sensitive composition of the present embodiment, the content of the resin, which is arbitrarily adjusted according to the kind of the compound represented by the above formula (1) to be used, is preferably 30 parts by weight or less per 100 parts by weight of the compound represented by the formula (1), more preferably 10 parts by weight or less, still more preferably 5 parts by weight or less, and particularly preferably 0 part by weight.

### (Resist Pattern Formation Method)

A resist pattern formation method of the present embodiment includes steps of forming a resist film by coating a substrate with the above radiation-sensitive composition, exposing the resist film, and developing the exposed resist film, thereby forming a resist pattern. The resist pattern of the present embodiment can also be formed as an upper layer resist in a multilayer process.

Specific examples of the resist pattern formation method include, but not particularly limited to, a method below. A resist film is formed by coating a conventionally publicly known substrate with the above radiation-sensitive composition using a coating means such as spin coating, flow casting coating, and roll coating. The conventionally publicly known substrate is not particularly limited. For example, a substrate for electronic components, and the one having a predetermined wiring pattern formed thereon, or the like can be exemplified. More specific examples include, but not particularly limited to, a substrate made of a metal such as a silicon wafer, copper, chromium, iron and aluminum, and a glass substrate. Examples of a wiring pattern material include, but not particularly limited to, copper, aluminum, nickel, and gold. Also if required, the substrate may be a substrate having an inorganic film and/or an organic film provided thereon. Examples of the inorganic film include, but not particularly limited to, an inorganic antireflection film (inorganic BARC). Examples of the organic film include, but not particularly limited to, an organic antireflection film (organic BARC). Surface treatment with hexamethylene disilazane or the like may be conducted.

Next, the coated substrate is heated if required. The heating conditions vary according to the content composition of the above radiation-sensitive composition, or the like, but are preferably 20 to 250°C, and more preferably 20 to 150°C. By heating, the adhesiveness of a resist to a substrate may improve, which is preferable. Then, the resist film is exposed to a desired pattern by any radiation selected from the group consisting of visible light, ultraviolet, excimer laser, electron beam, extreme ultraviolet (EUV), X-ray, and ion beam. The exposure conditions or the like are arbitrarily selected according to the compounding composition of the above radiation-sensitive composition, or the like. In the resist pattern formation method of the present embodiment, in order to stably form a fine pattern with a high degree of accuracy in exposure, the resist film is preferably heated after radiation irradiation. The heating conditions vary according to the compounding composition of the above radiation-sensitive composition, or the like, but are preferably 20 to 250°C, and more preferably 20 to 150°C.

Next, by developing the exposed resist film in a developing solution, a predetermined resist pattern can be formed. As the developing solution, a solvent having a solubility parameter (SP value) close to that of the compound represented by the above formula (1) (resist base material) to be used is preferably selected. A polar solvent such as a ketone-based solvent, an ester-based solvent, an alcohol-based solvent, an amide-based solvent, and an ether-based solvent; and a hydrocarbon-based solvent, or an alkaline aqueous solution can be used.

Examples of the ketone-based solvent include, but not particularly limited to, 1-octanone, 2-octanone, 1-nonanone, 2-nonanone, acetone, 4-heptanone, 1-hexanone, 2-hexanone, diisobutyl ketone, cyclohexanone, methylcyclohexanone, phenylacetone, methyl ethyl ketone, methyl isobutyl ketone, acetylacetone, acetonylacetone, ionone, diacetonyl alcohol, acetyl carbinol, acetophenone, methyl naphthyl ketone, isophorone, and propylene carbonate.

Examples of the ester-based solvent include, but not particularly limited to, methyl acetate, butyl acetate, ethyl acetate, isopropyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxypropionate, 3-methoxybutyl acetate, 3-methyl-3-methoxybutyl acetate, methyl formate, ethyl formate, butyl formate, propyl formate, ethyl lactate, butyl lactate, and propyl lactate.

Examples of the alcohol-based solvent include, but not particularly limited to, an alcohol such as methyl alcohol, ethyl alcohol, n-propyl alcohol, isopropyl alcohol (2-propanol), n-butyl alcohol, sec-butyl alcohol, tert-butyl alcohol, isobutyl alcohol, n-hexyl alcohol, 4-methyl-2-pentanol, n-heptyl alcohol, n-octyl alcohol, and n-decanol; a glycol-based solvent such as ethylene glycol, diethylene glycol, and triethylene glycol; and a glycol ether-based solvent such as ethylene glycol monomethyl ether, propylene glycol monomethyl ether, ethylene glycol monoethyl ether, propylene glycol monoethyl ether, diethylene glycol monomethyl ether, triethylene glycol monoethyl ether, and methoxymethyl butanol.

Examples of the ether-based solvent include, but not particularly limited to, dioxane and tetrahydrofuran in addition to the above glycol ether-based solvents.

Examples of the amide-based solvent which can be used include, but not particularly limited to, N-methyl-2-pyrrolidone, N,N-dimethylacetamide, N,N-dimethylformamide, phosphoric hexamethyltriamide, and 1,3-dimethyl-2-imidazolidinone.

Examples of the hydrocarbon-based solvent include, but not particularly limited to, an aromatic hydrocarbon-based solvent such as toluene and xylene; and an aliphatic hydrocarbon-based solvent such as pentane, hexane, octane, and decane.

A plurality of above solvents may be mixed, or the solvent may be used by mixing the solvent with a solvent other than those described above or water within the range having performance. However, in order to exhibit more than enough effect of the present invention, the water content ratio as the whole developing solution is less than 70% by mass, preferably less than 50% by mass, more preferably less than 30% by mass, and still more preferably less than 10% by mass. Particularly preferably, the developing solution is substantially moisture free. That is, the content of the organic solvent in the developing solution is 30% by mass or more and 100% by mass or less based on the total amount of the developing solution, preferably 50% by mass or more and 100% by mass or less, more preferably 70% by mass or more and 100% by mass or less, still more preferably 90% by mass or more and 100% by mass or less, and particularly preferably 95% by mass or more and 100% by mass or less.

Examples of the alkaline aqueous solution include, but not particularly limited to, an alkaline compound such as mono-, di- or tri-alkylamines, mono-, di- or trialkanolamines, heterocyclic amines, tetramethyl ammonium hydroxide (TMAH), and choline.

Particularly, the developing solution containing at least one kind of solvent selected from a ketone-based solvent, an ester-based solvent, an alcohol-based solvent, an amide-based solvent, and an ether-based solvent improves resist performance such as resolution and roughness of the resist pattern, which is preferable.

The vapor pressure of the developing solution is preferably 5 kPa or less at 20°C, more preferably 3 kPa or less, and particularly preferably 2 kPa or less. The evaporation of the developing solution on the substrate or in a developing cup is inhibited by setting the vapor pressure of the developing solution to 5 kPa or less, to improve temperature uniformity within a wafer surface, thereby resulting in improvement in size uniformity within the wafer surface.

Specific examples of developing solution having a vapor pressure of 5 kPa or less include, but not particularly limited to, a ketone-based solvent such as 1-octanone, 2-octanone, 1-nonanone, 2-nonanone, 4-heptanone, 2-hexanone, diisobutyl ketone, cyclohexanone, methylcyclohexanone, phenylacetone, and methyl isobutyl ketone; an ester-based solvent such as butyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxy propionate, 3-methoxy butyl acetate, 3-methyl-3-methoxy butyl acetate, butyl formate, propyl formate, ethyl lactate, butyl lactate, and propyl lactate; an alcohol-based solvent such as n-propyl alcohol, isopropyl alcohol, n-butyl alcohol, sec-butyl alcohol, tert-butyl alcohol, isobutyl alcohol, n-hexyl alcohol, 4-methyl-2-pentanol, n-heptyl alcohol, n-octyl alcohol, and n-decanol; a glycol-based solvent such as ethylene glycol, diethylene glycol, and triethylene glycol; a glycol ether-based solvent such as ethylene glycol monomethyl ether, propylene glycol monomethyl ether, ethylene glycol monoethyl ether, propylene glycol monoethyl ether, diethylene glycol monomethyl ether, triethylene glycol monoethyl ether, and methoxymethyl butanol; an ether-based solvent such as tetrahydrofuran; an amide-based solvent such as N-methyl-2-pyrrolidone, N,N-dimethylacetamide, and N,N-dimethylformamide; an aromatic hydrocarbon-based solvent such as toluene and xylene; and an aliphatic hydrocarbon-based solvent such as octane and decane.

Specific examples of developing solution having a vapor pressure of 2 kPa or less which is a particularly preferable range include, but not particularly limited to, a ketone-based solvent such as 1-octanone, 2-octanone, 1-nonanone, 2-nonanone, 4-heptanone, 2-hexanone, diisobutyl ketone, cyclohexanone, methylcyclohexanone, and phenylacetone; an ester-based solvent such as butyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxy propionate, 3-methoxy butyl acetate, 3-methyl-3-methoxy butyl acetate, ethyl lactate, butyl lactate, and propyl lactate; an alcohol-based solvent such as n-butyl alcohol, sec-butyl alcohol, tert-butyl alcohol, isobutyl alcohol, n-hexyl alcohol, 4-methyl-2-pentanol, n-heptyl alcohol, n-octyl alcohol, and n-decanol; a glycol-based solvent such as ethylene glycol, diethylene glycol, and triethylene glycol; a glycol ether-based solvent such as ethylene glycol monomethyl ether, propylene glycol monomethyl ether, ethylene glycol monoethyl ether, propylene glycol monoethyl ether, diethylene glycol monomethyl ether, triethylene glycol monoethyl ether, and methoxymethyl butanol; an amide-based solvent such as N-methyl-2-pyrrolidone, N,N-dimethylacetamide, and N,N-dimethylformamide; an aromatic hydrocarbon-based solvent such as xylene; and an aliphatic hydrocarbon-based solvent such as octane and decane.

To the developing solution, a surfactant can be added in an appropriate amount, if required.

The surfactant is not particularly limited but, for example, an ionic or nonionic fluorine-based and/or silicon-based surfactant can be used. Examples of the fluorine-based and/or silicon-based surfactant include, but not particularly limited to, the surfactants described in Japanese Patent Application Laid-Open Nos. 62-36663, 61-226746, 61-226745, 62-170950, 63-34540, 7-230165, 8-62834, 9-54432, and 9-5988, and U.S. Pat. Nos. 5,405,720, 5,360,692, 5,529,881, 5,296,330, 5,436,098, 5,576,143, 5,294,511, and 5,824,451. The surfactant is preferably a nonionic surfactant. The nonionic surfactant is not particularly limited, but a fluorine-based surfactant or a silicon-based surfactant is more preferably used.

The amount of the surfactant used is usually 0.001 to 5% by mass based on the total amount of the developing solution, preferably 0.005 to 2% by mass, and more preferably 0.01 to 0.5% by mass.

The development method is, for example, a method for dipping a substrate in a bath filled with a developing solution for a fixed time (dipping method), a method for raising a developing solution on a substrate surface by the effect of a surface tension and keeping it still for a fixed time, thereby conducting the development (puddle method), a method for spraying a developing solution on a substrate surface (spraying method), and a method for continuously ejecting a developing solution on a substrate rotating at a constant speed while scanning a developing solution ejecting nozzle at a constant rate (dynamic dispense method), or the like may be applied. The time for conducting the pattern development is not particularly limited, but is preferably 10 seconds to 90 seconds.

After the step of conducting development, a step of stopping the development by the replacement with another solvent may be practiced.

A step of rinsing the resist film with a rinsing solution containing an organic solvent is preferably provided after the development.

The rinsing solution used in the rinsing step after development is not particularly limited as long as the rinsing solution does not dissolve the formed resist pattern. A solution containing a general organic solvent or water may be used as the rinsing solution. As the rinsing solution, a rinsing solution containing at least one kind of organic solvent selected from a hydrocarbon-based solvent, a ketone-based solvent, an ester-based solvent, an alcohol-based solvent, an amide-based solvent, and an ether-based solvent is preferably used. More preferably, after development, a step of rinsing the film by using a rinsing solution containing at least one kind of organic solvent selected from the group consisting of a ketone-based solvent, an ester-based solvent, an alcohol-based solvent and an amide-based solvent is conducted. Still more preferably, after development, a step of rinsing the film by using a rinsing solution containing an alcohol-based solvent or an ester-based solvent is conducted. Further more preferably, after development, a step of rinsing the film by using a rinsing solution containing a monohydric alcohol is conducted. Particularly preferably, after development, a step of rinsing the film by using a rinsing solution containing a monohydric alcohol having 5 or more carbon atoms is conducted. The time for rinsing the pattern is not particularly limited, but is preferably 10 seconds to 90 seconds.

Herein, examples of the monohydric alcohol used in the rinsing step after development include, but not particularly limited to, a linear, branched or cyclic monohydric alcohol. Specifically, 1-butanol, 2-butanol, 3-methyl-1-butanol, tert-butyl alcohol, 1-pentanol, 2-pentanol, 1-hexanol, 4-methyl-2-pentanol, 1-heptanol, 1-octanol, 2-hexanol, cyclopentanol, 2-heptanol, 2-octanol, 3-hexanol, 3-heptanol, 3-octanol, and 4-octanol or the like can be used. As a particularly preferable monohydric alcohol having 5 or more carbon atoms, 1-hexanol, 2-hexanol, 4-methyl-2-pentanol, 1-pentanol, and 3-methyl-1-butanol or the like can be used.

A plurality of these components may be mixed, or the component may be used by mixing the component with an organic solvent other than those described above.

The water content ratio in the rinsing solution is preferably 10% by mass or less, more preferably 5% by mass or less, and particularly preferably 3% by mass or less. By setting the water content ratio to 10% by mass or less, better development characteristics can be obtained.

The vapor pressure at 20°C of the rinsing solution used after development is preferably 0.05 kPa or more and 5 kPa or less, more preferably 0.1 kPa or more and 5 kPa or less, and most preferably 0.12 kPa or more and 3 kPa or less. By setting the vapor pressure of the rinsing solution to 0.05 kPa or more and 5 kPa or less, the temperature uniformity in the wafer surface is further enhanced and moreover, swelling due to permeation of the rinsing solution is further inhibited. As a result, the dimensional uniformity in the wafer surface is further improved.

The rinsing solution may also be used after adding an appropriate amount of a surfactant to the rinsing solution.

In the rinsing step, the wafer after development is rinsed using the organic solvent-containing rinsing solution. The method for rinsing treatment is not particularly limited. However, for example, a method for continuously ejecting a rinsing solution on a substrate spinning at a constant speed (spin coating method), a method for dipping a substrate in a bath filled with a rinsing solution for a fixed time (dipping method), and a method for spraying a rinsing solution on a substrate surface (spraying method), or the like can be applied. Above all, it is preferable to conduct the rinsing treatment by the spin coating method and after the rinsing, spin the substrate at a rotational speed of 2,000 rpm to 4,000 rpm, to remove the rinsing solution from the substrate surface.

After forming the resist pattern, a pattern wiring substrate is obtained by etching. Etching can be conducted by a publicly known method such as dry etching using plasma gas, and wet etching with an alkaline solution, a cupric chloride solution, and a ferric chloride solution or the like.

After forming the resist pattern, plating can also be conducted. Examples of the above plating method include, but not particularly limited to, copper plating, solder plating, nickel plating, and gold plating.

The remaining resist pattern after etching can be peeled by an organic solvent. Examples of the above organic solvent include, but not particularly limited to, PGMEA (propylene glycol monomethyl ether acetate), PGME (propylene glycol monomethyl ether), and EL (ethyl lactate). Examples of the above peeling method include, but not particularly limited to, a dipping method and a spraying method. A wiring substrate having a resist pattern formed thereon may be a multilayer wiring substrate, and may have a small diameter through hole.

In the present embodiment, the wiring substrate can also be formed by a method for forming a resist pattern, then depositing a metal in vacuum, and subsequently dissolving the resist pattern in a solution, i.e., a liftoff method.

### Examples

The embodiment of the present invention will be more specifically described with reference to examples below. However, the present invention is not limited to these examples. Hereinafter, the structure of a compound in synthesis examples, examples, and comparative example was confirmed by ¹H-NMR measurement.

### (Synthesis Example 1) Synthesis of BisN-1

In a container (internal capacity: 100 mL) equipped with a stirrer, a condenser tube, and a burette, 3.20 g (20 mmol) of 2,6-naphthalenediol (reagent manufactured by Sigma-Aldrich Co. LLC), 1.82 g (10 mmol) of 4-biphenylaldehyde (manufactured by Mitsubishi Gas Chemical Company, Inc.), and 30 mL of methyl isobutyl ketone were charged, and 5 mL of 95% by mass of sulfuric acid was added thereto. The contents were reacted by stirring at 100°C for 6 hours to prepare a reaction solution. Next, the reaction solution was concentrated. The reaction product was precipitated by the addition of 50 g of pure water to the obtained concentrate. After cooling to room temperature, the solid matter was separated by filtration. The obtained solid matter was filtered, dried, and then separated and purified by column chromatography to obtain 3.05 g of the objective compound (BisN-1) represented by the following formula (BisN-1).

As a result of conducting 400 MHz-¹H-NMR of the obtained compound (BisN-1), the following peaks were found, and the compound was confirmed to have a chemical structure of the following formula (BisN-1). Also, the position of substitution with 2,6-dihydroxynaphthol in the obtained compound (BisN-1) was confirmed to be position 1 from doublet signals of protons at positions 3 and 4.
¹H-NMR: (d-DMSO, internal standard TMS)
δ (ppm) 9.7 (2H, O-H), 7.2 - 8.5 (19H, Ph-H), 6.6 (1H, C-H)

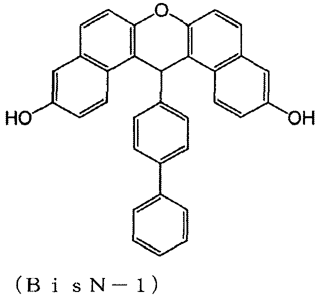

### (Synthesis Example 2) Synthesis of BisN-2

3.00 g of the objective compound (BisN-2) represented by the following formula (BisN-2) was obtained by synthesis in the same way as in Synthesis Example 1 except that 4-biphenylaldehyde was changed to 5.2 g (10 mmol) of 3-iodobenzaldehyde.

As a result of conducting 400 MHz-¹H-NMR of the obtained compound (BisN-2), the following peaks were found, and the compound was confirmed to have a chemical structure of the following formula (BisN-2). δ (ppm) 9.7 (2H, O-H), 7.0 - 8.5 (14H, Ph-H), 6.5 (1H, C-H)

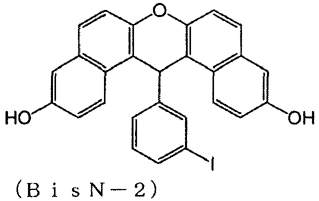

### (Synthesis Example 3) Synthesis of BisN-3

2.95 g of the objective compound (BisN-3) represented by the following formula (BisN-3) was obtained by synthesis in the same way as in Synthesis Example 1 except that 4-biphenylaldehyde was changed to 5.2 g (10 mmol) of 4-iodobenzaldehyde.

As a result of conducting 400 MHz-¹H-NMR of the obtained compound (BisN-3), the following peaks were found, and the compound was confirmed to have a chemical structure of the following formula (BisN-3). δ (ppm) 9.7 (2H, O-H), 7.2 - 8.5 (14H, Ph-H), 6.5 (1H, C-H)

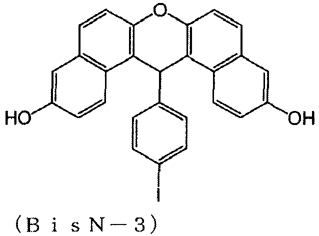

### (Synthesis Example 4) Synthesis of BisN-4

1.92 g of the objective compound (BisN-4) represented by the following formula (BisN-4) was obtained by synthesis in the same way as in Synthesis Example 1 except that 4-biphenylaldehyde was changed to 5.2 g (10 mmol) of 5-vanillin.

As a result of conducting 400 MHz-¹H-NMR of the obtained compound (BisN-4), the following peaks were found, and the compound was confirmed to have a chemical structure of the following formula (BisN-4). δ (ppm) 9.7, 9.3 (3H, O-H), 7.2 - 8.5 (12H, Ph-H), 6.4 (1H, C-H), 3.7 (3H, O-C-H)

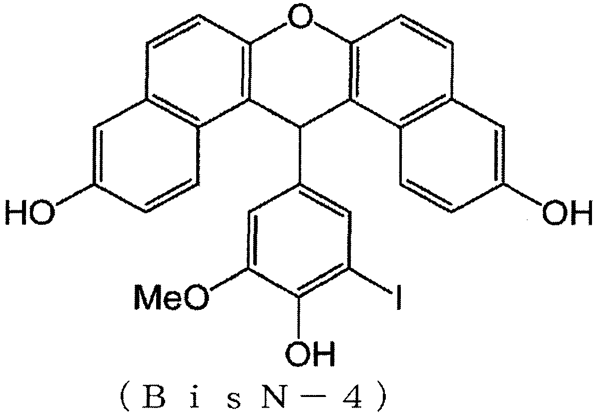

### (Synthesis Example 5) Synthesis of BisN-5

3.30 g of the objective compound (BisN-5) represented by the following formula (BisN-5) was obtained by synthesis in the same way as in Synthesis Example 2 except that 2,6-naphthalenediol was changed to 3.20 g (20 mmol) of 2,7-naphthalenediol (reagent manufactured by Sigma-Aldrich Co., LLC).

As a result of conducting 400 MHz-¹H-NMR of the obtained compound (BisN-5), the following peaks were found, and the compound was confirmed to have a chemical structure of the following formula (BisN-5).
δ (ppm) 10.0 (2H, O-H), 7.0 - 7.8 (14H, Ph-H), 6.1 (1H, C-H)

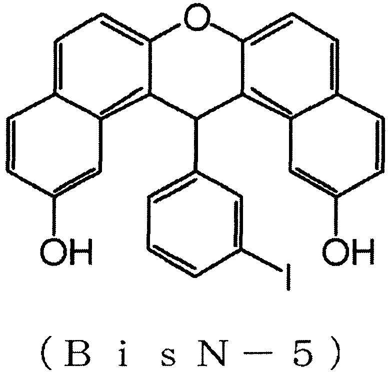

### (Synthesis Example 6) Synthesis of BisN-6

2.70 g of the objective compound (BisN-6) represented by the following formula (BisN-6) was obtained by synthesis in the same way as in Synthesis Example 3 except that 2,6-naphthalenediol was changed to 3.20 g (20 mmol) of 2,7-naphthalenediol (reagent manufactured by Sigma-Aldrich Co., LLC).

As a result of conducting 400 MHz-¹H-NMR of the obtained compound (BisN-6), the following peaks were found, and the compound was confirmed to have a chemical structure of the following formula (BisN-6). δ (ppm) 9.9 (2H, O-H), 7.0 - 8.3 (14H, Ph-H), 6.1 (1H, C-H)

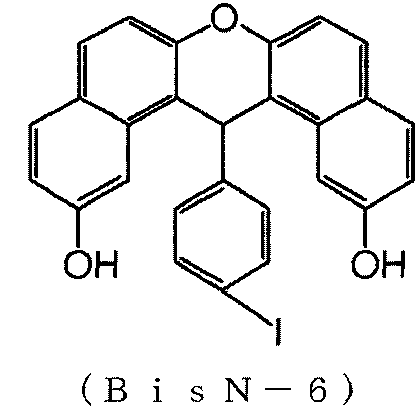

### (Synthesis Example 7) Synthesis of BisN-7

1.50 g of the objective compound (BisN-7) represented by the following formula (BisN-7) was obtained by synthesis in the same way as in Synthesis Example 4 except that 2,6-naphthalenediol was changed to 3.20 g (20 mmol) of 2,7-naphthalenediol (reagent manufactured by Sigma-Aldrich Co., LLC).

As a result of conducting 400 MHz-¹H-NMR of the obtained compound (BisN-7), the following peaks were found, and the compound was confirmed to have a chemical structure of the following formula (BisN-7). δ (ppm) 9.9, 9.4 (3H, O-H), 7.0 - 8.3 (12H, Ph-H), 6.0 (1H, C-H), 3.8 (3H, O-C-H)

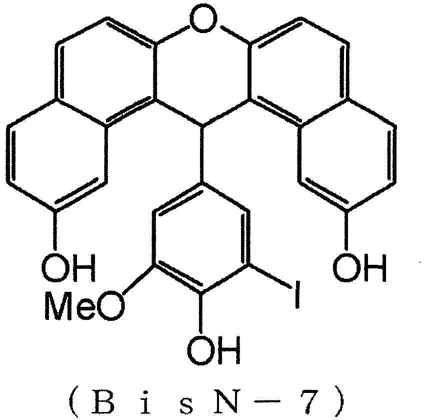

### [Examples 1 to 10 and Comparative Example 1]

### (1) Preparation of Radiation-Sensitive Composition

The components described in Table 1 were prepared into a homogeneous solution. Subsequently, the obtained homogeneous solution was filtered through a Teflon(R) membrane filter with a pore diameter of 0.1 µm to prepare a radiation-sensitive composition. Each prepared radiation-sensitive composition was evaluated as described below.

**[Table 1]**

| | Resist base material (A) | Optically active compound (B) | Solvent |
|---|---|---|---|
| | (g) | (g) | (g) |
| Example 1 | BisN-1 | P-1 | S-1 |
| | 0.5 | 1.5 | 30.0 |
| Example 2 | BisN-2 | P-1 | S-1 |
| | 0.5 | 1.5 | 30.0 |
| Example 3 | BisN-3 | P-1 | S-1 |
| | 0.5 | 1.5 | 30.0 |
| Example 4 | BisN-4 | P-1 | S-1 |
| | 0.5 | 1.5 | 30.0 |
| Example 5 | BisN-5 | P-1 | S-1 |
| | 0.5 | 1.5 | 30.0 |
| Example 6 | BisN-6 | P-1 | S-1 |
| | 0.5 | 1.5 | 30.0 |
| Example 7 | BisN-7 | P-1 | S-1 |
| | 0.5 | 1.5 | 30.0 |
| Example 8 | BisN-1 | P-2 | S-1 |
| | 0.5 | 1.5 | 30.0 |
| Example 9 | BisN-1 | P-3 | S-1 |
| | 0.5 | 1.5 | 30.0 |
| Example 10 | BisN-1 | P-4 | S-1 |
| | 0.5 | 1.5 | 30.0 |
| Comparative Example 1 | PHS-1 | P-1 | S-1 |
| | 0.5 | 1.5 | 30.0 |

The following was used as the resist base material of Comparative Example 1.

### PHS-1: polyhydroxystyrene (Mw = 8000) (Sigma-Aldrich Co., LLC)

In Table 1, the following was used as the optically active compound (B).
P-1: naphthoquinonediazide based photosensitizing agent of the chemical structural formula (G) (4NT-300, Toyo Gosei Co., Ltd.)
P-2: naphthoquinonediazide based photosensitizing agent of the chemical structural formula (G-1) (TS-200, Sanbo Chemical Ind., Ltd.)
P-3: naphthoquinonediazide based photosensitizing agent of the chemical structural formula (G-2) (TKE1-510, Sanbo Chemical Ind., Ltd.)
P-4: naphthoquinonediazide based photosensitizing agent of the chemical structural formula (G-3) (PQ-614, Sanbo Chemical Ind., Ltd.)

The following was used as the solvent.
S-1: propylene glycol monomethyl ether (Tokyo Kasei Kogyo Co., Ltd.)

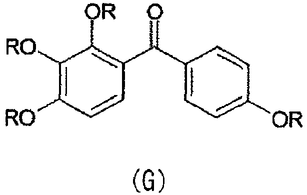

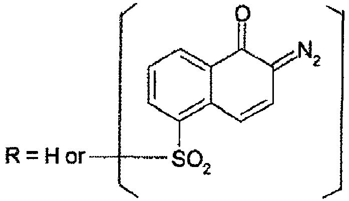

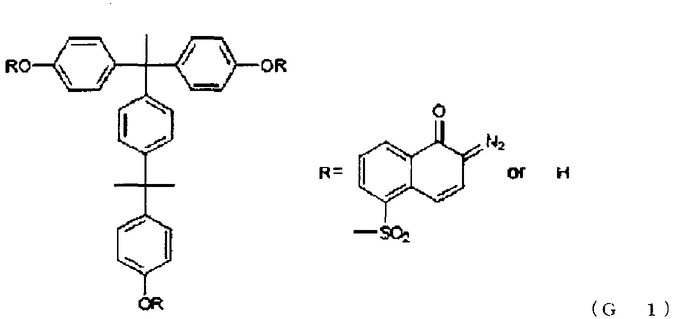

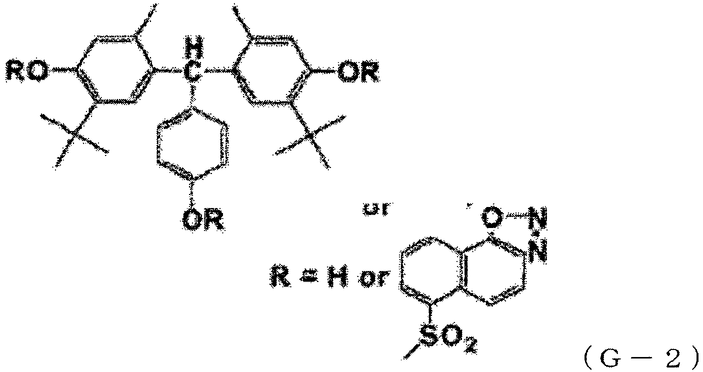

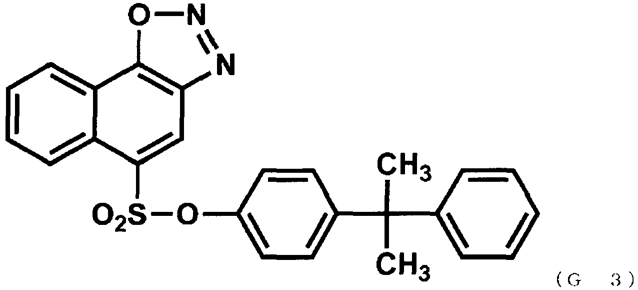

### (2) Evaluation of Resist Performance

A clean silicon wafer was spin coated with the radiation-sensitive composition obtained in the above (1), and then prebaked (PB) before exposure in an oven of 110°C to form a resist film with a thickness of 200 nm. The resist film was exposed to ultraviolet using an ultraviolet exposure apparatus (mask aligner MA-10 manufactured by Mikasa Co., Ltd.). The ultraviolet lamp used was a super high pressure mercury lamp (relative intensity ratio: g-ray:h-ray:i-ray:j-ray = 100:80:90:60). After irradiation, the resist film was heated at 110°C for 90 seconds, and immersed in 2.38% by mass TMAH alkaline developing solution for 60 seconds for development. Subsequently, the resist film was washed with ultrapure water for 30 seconds, and dried to form a 5 µm positive type resist pattern.

The obtained line and space in the formed resist pattern were observed by a scanning electron microscope (S-4800 manufactured by Hitachi High-Technologies Corporation). As for the line edge roughness, a pattern having asperities of less than 50 nm was evaluated as goodness.

The radiation-sensitive compositions obtained in Examples 1 to 10 could produce resist patterns with good resolution of 5 µm. The roughness of the patterns was also small and good.

The radiation-sensitive composition obtained in Comparative Example 1 could produce a resist pattern with good resolution of 5 µm. However, the roughness of the pattern was large and poor.

As described above, it was evident that the radiation-sensitive compositions obtained in in the present Examples 1 to 10 can form a resist pattern having smaller roughness and a better shape, as compared with the composition obtained in Comparative Example 1. As long as the above configuration of the present invention is met, radiation-sensitive compositions other than those described in examples also exhibit the same effects.

### Industrial Applicability

The present invention is preferably used in a radiation-sensitive composition useful as a resist material, and a resist pattern formation method using the composition. Particularly, the radiation-sensitive composition of the present invention contains a resist base material represented by a specific chemical structural formula, an optically active compound, and a solvent and is thereby useful as, for example, a non-chemical amplification low molecular resist material.

## Claims

1. A radiation-sensitive composition comprising (A) a resist base material, (B) an optically active diazonaphthoquinone compound, and (C) a solvent, wherein
the content of a solid component in the composition is within the range of 1 to 80% by mass, the content of the solvent is within the range of 20 to 99% by mass, and
the resist base material (A) is a compound represented by the following formula (1): 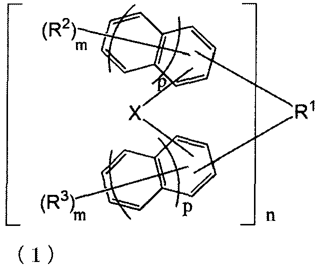 wherein X are each independently an oxygen atom, a sulfur atom, or a non-crosslinked state; R¹ is a single bond or a 2n-valent group of 1 to 30 carbon atoms; R² and R³ are each independently a linear, branched, or cyclic alkyl group of 1 to 10 carbon atoms, an aryl group of 6 to 10 carbon atoms, an alkenyl group of 2 to 10 carbon atoms, a hydroxyl group, or a thiol group; m are each independently an integer of 0 to 7, wherein at least one of m is an integer of 1 to 7; p are each independently 0 or 1; and n is an integer of 1 to 4, wherein at least one selected from the group consisting of R² and R³ is at least one kind selected from a hydroxyl group and a thiol group.

2. The radiation-sensitive composition according to claim 1, wherein in the formula (1), at least one selected from the group consisting of R¹, R², and R³ is a group containing an iodine atom.

3. The radiation-sensitive composition according to claim 1 or 2, wherein in the formula (1), X is an oxygen atom.

4. The radiation-sensitive composition according to any one of claims 1 to 3, wherein in the formula (1), X is an oxygen atom, one of R² is a hydroxyl group, and one of R³ is a hydroxyl group.

5. The radiation-sensitive composition according to any one of claims 1 to 4, wherein the solid component comprises resist base material (A)/optically active diazonaphthoquinone compound (B)/optional component (D) at a ratio of 1 to 99/99 to 1/0 to 98 in % by mass based on the solid component.

6. The radiation-sensitive composition according to any one of claims 1 to 5, wherein the radiation-sensitive composition is capable of forming an amorphous film by spin coating.

7. The radiation-sensitive composition according to claim 6, wherein the dissolution rate of the amorphous film in a developing solution at 23°C is 5 angstrom/sec or less.

8. The radiation-sensitive composition according to claim 6 or 7, wherein the dissolution rate of an exposed portion of the amorphous film after irradiation with g-ray, h-ray, i-ray, KrF excimer laser, ArF excimer laser, extreme ultraviolet, electron beam, or X-ray or after heating at 20 to 500°C, in a developing solution at 23°C is 10 angstrom/sec or more.

9. An amorphous film formed by spin coating with the radiation-sensitive composition according to any one of claims 1 to 8.

10. The amorphous film according to claim 9, wherein the dissolution rate of an exposed portion of the amorphous film after irradiation with g-ray, h-ray, i-ray, KrF excimer laser, ArF excimer laser, extreme ultraviolet, electron beam, or X-ray or after heating at 20 to 500°C, in a developing solution at 23°C is 10 angstrom/sec or more.

11. A method for forming a resist pattern, comprising the steps of: coating a substrate with the radiation-sensitive composition according to any one of claims 1 to 8, thereby forming a resist film; exposing the resist film; and developing the exposed resist film.
